# EUROPEAN PATENT SPECIFICATION

(11) **EP 3 828 946 B1**
(45) Date of publication and mention of the grant of the patent: **28.10.2026**
(21) Application number: 18927870.8
(22) Date of filing: 29.11.2018
(51) Int. Cl.: H10K 85/60, H10K 50/11, H10K 50/18

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 23.07.2018 KR 20180085382
(43) Date of publication of application: 02.06.2021
(73) Proprietor: Samsung Display Co., Ltd., Yongin-si, Gyeonggi-Do 17113 (KR)
(72) Inventor: YOON, Seok Gyu, Yongin-Si Gyeonggi-do 17113 (KR); KIM, Hyo Jeong, Yongin-Si Gyeonggi-do 17113 (KR); SHIN, Hyo Sup, Yongin-Si Gyeonggi-do 17113 (KR)
(74) Representative: Dr. Weitzel & Partner
(86) International application number: PCT/KR2018/015003
(87) International publication number: WO 2020/022579

(56) References cited:
- EP-A1- 3 275 968
- JP-A- 2012 089 513
- JP-B2- 6 305 068
- KR-A- 20150 139 709
- KR-A- 20160 008 570
- KR-A- 20180 078 637
- KR-A- 20180 079 109
- US-A1- 2014 312 338
- US-A1- 2016 093 823
- US-A1- 2017 069 864

## Description

### TECHNICAL FIELD

The invention relates to an organic light-emitting device.

### BACKGROUND ART

Organic light-emitting devices (OLEDs) are self-emissive devices that, as compared with devices of the related art, have wide viewing angles, high contrast ratios, short response times, and excellent characteristics in terms of brightness, driving voltage, and response speed, and produce full-color images.

OLEDs may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state to thereby generate light.

US 2014/312338 A1 describes an organic electroluminescence device comprising: an anode, an emitting layer, an electron transporting zone, and a cathode in this sequential order, wherein the electron transporting zone comprises an aromatic heterocyclic derivative that is represented by formula (1):

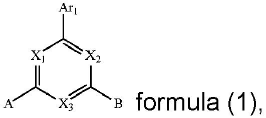

wherein Ar₁, X₁ to X₃, A, and B are defined as disclosed in US 2014/312338 A1. The host material is preferably an anthracene derivative and a polycyclic aromatic skeleton-containing compound, preferably the anthracene derivative. In the organic electroluminescence device the emitting layer comprises a dopant material that exhibits fluorescent emission having a main peak wavelength of 500 nm or less. The host material and the dopant material are each only one compound. As for the combination of the host material and the dopant material, it is preferable that the host material is an anthracene derivative and the dopant material is a fluoranthene derivative or a boron complex.

### DESCRIPTION OF EMBODIMENTS

### TECHNICAL PROBLEM

The present invention includes an organic light-emitting device including a hole blocking layer and an electron blocking layer.

### TECHNICAL SOLUTION TO PROBLEM

The present invention is defined by the subject matter of independent claim 1. Preferred embodiments are defined in the sub claims. The invention is defined by the claims. Embodiments not covered by the claimed subject-matter do not form part of the invention.

According to the invention, an organic light-emitting device includes: an anode; a cathode; an organic layer located between the anode and the cathode and including an emission layer;
an electron blocking layer located between the anode and the emission layer and in direct contact with the emission layer; and a hole blocking layer located between the cathode and the emission layer and in direct contact with the emission layer, the emission layer includes a host and a dopant, the electron blocking layer comprises an electron blocking material, the hole blocking layer includes a hole blocking material, and the host, the dopant, the electron blocking material, and the hole blocking material each satisfy Equations 1-1 to 1-4:

   $T 1 \left(EB\right) \geq T 1 \left(H\right)$ Equation 1-1

   $T 1 \left(EB\right) \geq T 1 \left(D\right)$ Equation 1-2

   $T 1 \left(HB\right) > T 1 \left(H\right)$ Equation 1-3

   $T 1 \left(HB\right) > T 1 \left(D\right)$ Equation 1-4
wherein, in Equations 1-1 and 1-4,
T1(EB) indicates a lowest excited triplet energy level of the electron blocking material,
T1(HB) indicates a lowest excited triplet energy level of the hole blocking material,
T1(H) indicates a lowest excited triplet energy level of the host, and
T1(D) indicates a lowest excited triplet energy level of the dopant, wherein the organic layer comprises an electron transport layer between the cathode and the hole blocking layer, the electron transport layer comprises an electron transporting material,
the dopant and the electron transporting material each satisfy Equation 7: $T 1 \left(D\right) \geq T 1 \left(ET\right)$ Equation 7
wherein, in Equation 7,
T1(D) indicates a lowest excited triplet energy level of the dopant, and
T1(ET) indicates a lowest excited triplet energy level of the electron transporting material,
whereby the host comprises a first host and a second host,
wherein the first host comprises a compound represented by Formula 1, and the second host comprises a compound represented by Formula 2: 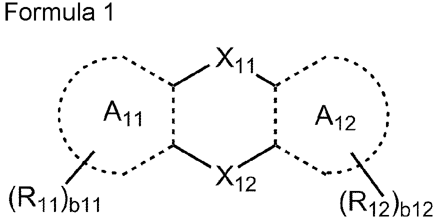 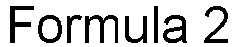 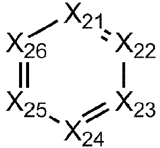
wherein, in Formulae 1 and 2,
X₁₁ is selected from O, S, N(R₁₃), and C(R₁₃)(R₁₄),
X₁₂ is selected from a single bond, O, S, N(R₁₅), and C(R₁₅)(R₁₆),
A₁₁ and A₁₂ are each independently selected from a C₅-C₆₀ carbocyclic group and a C₁-C₆₀ heterocyclic group,
R₁₁ to R₁₆ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), - P(=O)(Q₁)(Q₂), and -P(=S)(Q₁)(Q₂),
b11 and b12 are each independently selected from 1, 2, 3, 4, 5, and 6,
wherein Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a biphenyl group, and a terphenyl group,
X₂₁ is N or C(R₂₁), X₂₂ is N or C(R₂₂), X₂₃ is N or C(R₂₃), X₂₄ is N or C(R₂₄), X₂₅ is N or C(R₂₅), and X₂₆ is N or C(R₂₆), provided that at least one of X₂₁ to X₂₆ is N,
R₂₁ to R₂₆ are each independently selected from hydrogen, deuterium, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
at least one of R₂₁ to R₂₆ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

According to one or more embodiments, the host, the dopant, the electron blocking material, and the hole blocking material may each satisfy Equations 1-11, 1-21, 1-31, and/or 1-41:

$1.0 eV \geq T 1 \left(EB\right) - T 1 \left(H\right) \geq 0.01 eV$ Equation 1-11

$1.0 eV \geq T 1 \left(EB\right) - T 1 \left(D\right) \geq 0.01 eV$ Equation 1-21

$1.0 eV \geq T 1 \left(HB\right) - T 1 \left(H\right) \geq 0.01 eV$ Equation 1-31

$1.0 eV \geq T 1 \left(HB\right) - T 1 \left(D\right) \geq 0.01 eV .$ Equation 1-41

In some embodiments, the electron blocking material may include a compound represented by Formula 1:

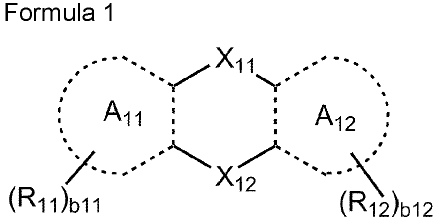

wherein, in Formula 1,
X₁₁ may be selected from O, S, N(R₁₃), and C(R₁₃)(R₁₄),
X₁₂ may be selected from a single bond, O, S, N(R₁₅), and C(R₁₅)(R₁₆),
A₁₁ and A₁₂ may each independently be selected from a C₅-C₆₀ carbocyclic group and a C₁-C₆₀ heterocyclic group,
R₁₁ to R₁₆ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂), and
b11 and b12 may each independently be selected from 1, 2, 3, 4, 5, and 6,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a biphenyl group, and a terphenyl group.

In some embodiments, a thickness (D_{E}) of the emission layer ≥ a thickness (D_{EB}) of the electron blocking layer.

In some embodiments, a thickness of the electron blocking layer may be in a range of 5 - 20 nm [50 - 200 Å].

In some embodiments, the hole blocking material may include a compound represented by Formula 2:

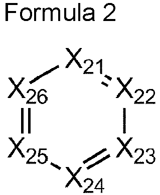

wherein, in Formula 2,
X₂₁ may be N or C(R₂₁), X₂₂ may be N or C(R₂₂), X₂₃ may be N or C(R₂₃), X₂₄ may be N or C(R₂₄), X₂₅ may be N or C(R₂₅), and X₂₆ may be N or C(R₂₆), provided that at least one selected from X₂₁ to X₂₆ may be N,
R₂₁ to R₂₆ may each independently be selected from hydrogen, deuterium, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
at least one of R₂₁ to R₂₆ may be selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

In some embodiments, a thickness (D_{E}) of the emission layer ≥ a thickness (D_{HB}) of the hole blocking layer.

In some embodiments, a thickness of the hole blocking layer may be in a range of 5 - 20 nm [50 - 200 Å].

According to the invention, the host includes a first host and a second host.

According to one or more embodiments, the first host may be a hole transporting host not including an electron transporting moiety, and the second host may be an electron transporting host including at least one electron transporting moiety.

The first host includes the compound represented by Formula 1, and the second host includes the compound represented by Formula 2.

In some embodiments, the first host may be identical to the electron blocking material.

In some embodiments, the second host may be identical to the hole blocking material.

In some embodiments, the dopant may emit delayed fluorescence or fluorescence.

In some embodiments, the dopant may further satisfy Equation 3:

$\left|S1\left(D\right)-T1\left(D\right)\right| \leq 0.5 eV$ Equation 3
wherein, in Equation 3,
T1(D) indicates a lowest excited triplet energy level of the dopant, and
S1(D) indicates a lowest excited singlet energy level of the dopant.

In some embodiments, the dopant may further satisfy Equation 4 and/or Equation 5:

$2.65 eV \leq S 1 \left(D\right) \leq 2.85 eV$ Equation 4

$2.65 eV \leq T 1 \left(D\right) \leq 3.05 eV$ Equation 5
wherein, in Equations 4 and 5,
T1(D) indicates a lowest excited triplet energy level of the dopant, and
S1(D) indicates a lowest excited singlet energy level of the dopant.

In some embodiments, the dopant may be represented by Formula 4:
In some embodiments, the organic layer may include a hole transport layer located between the anode and the electron blocking layer,
the hole transport layer may include a hole transporting material, and
the host and the hole transporting material may each satisfy Equation 6:

   $T 1 \left(H\right) \geq T 1 \left(HT\right)$ Equation 6
wherein, in Equation 6,
T1(H) indicates a lowest excited triplet energy level of the host, and
T1(HT) indicates a lowest excited triplet energy level of the hole transporting material.
The organic layer includes an electron transport layer located between the cathode and the hole blocking layer,the electron transport layer includes an electron transporting material, and
the dopant and the electron transporting material each satisfy Equation 7:

   $T 1 \left(D\right) \geq T 1 \left(ET\right)$ Equation 7
wherein, in Equation 7,
T1(D) indicates a lowest excited triplet energy level of the dopant, and
T1(ET) indicates a lowest excited triplet energy level of the electron transporting material.

### ADVANTAGEOUS EFFECTS OF DISCLOSURE

An organic light-emitting device including the electron blocking layer and the hole blocking layer has improved efficiency and lifespan.

### BRIEF DESCRIPTION OF DRAWINGS

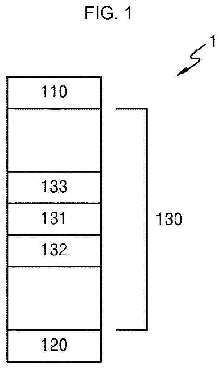

FIG. 1 illustrates a schematic cross-sectional view of an embodiment of an organic light-emitting device.

### MODE OF DISCLOSURE

As the inventive concept allows for various changes and numerous embodiments, particular embodiments will be illustrated in the drawings and described in detail in the written description. Effects, features, and a method of achieving the inventive concept will be obvious by referring to example embodiments of the inventive concept with reference to the attached drawings. The inventive concept may, however, be embodied in many different forms and should not be construed as being limited to the embodiments set forth herein.

Hereinafter, the inventive concept will be described in detail by explaining example embodiments of the inventive concept with reference to the attached drawings. Like reference numerals in the drawings denote like elements, and thus their description will be omitted.

In the embodiments described in the present specification, an expression used in the singular encompasses the expression of the plural, unless it has a clearly different meaning in the context.

In the present specification, it is to be understood that the terms such as "including," "having," and "comprising" are intended to indicate the existence of the features or components disclosed in the specification, and are not intended to preclude the possibility that one or more other features or components may exist or may be added.

It will be understood that when a layer, region, or component is referred to as being "on" or "onto" another layer, region, or component, it may be directly or indirectly formed over the other layer, region, or component. That is, for example, intervening layers, regions, or components may be present.

Sizes of components in the drawings may be exaggerated for convenience of explanation. In other words, since sizes and thicknesses of components in the drawings are arbitrarily illustrated for convenience of explanation, the following embodiments are not limited thereto.

The "lowest excited triplet energy level" as used herein was measured as follows: a compound was deposited on a quartz substrate to a thickness of 600 Å to prepare a sample. A photoluminescence spectrum of the sample was obtained at a temperature of 4 Kelvins (K), a first peak (a peak having the shortest wavelength) of the photoluminescence spectrum was analyzed to thereby calculate the lowest excited triplet energy level (a T1 energy level).

The term "organic layer" as used herein refers to a single and/or a plurality of layers between an anode and a cathode in an organic light-emitting device. A material included in the "organic layer" is not limited to an organic material.

As used herein, the expression the "(organic layer) includes a compound represented by Formula 1" may be construed as meaning the "(organic layer) may include one compound that is represented by Formula 1 or two different compounds that are represented by Formula 1".

The inventive concept will now be described more fully with reference to the accompanying drawings, in which exemplary embodiments of the inventive concept are shown.

FIG. 1 is a schematic view of an organic light-emitting device 1 according to an embodiment.

As shown in FIG. 1, the organic light-emitting device 1 includes: an anode 110; a cathode 120; an organic layer 130 located between the anode 110 and the cathode 120 and including an emission layer 131; an electron blocking layer 132 located between the anode 110 and the emission layer 131 and in direct contact with the emission layer 131; and a hole blocking layer 133 located between the cathode 120 and the emission layer 131 and in direct contact with the emission layer 131, wherein the emission layer 131 includes a host and a dopant, the electron blocking layer 132 includes an electron blocking material, a hole blocking layer 133 includes a hole blocking material, and the host, the dopant, the electron blocking material, and the hole blocking material each satisfy Equations 1-1 to 1-4:

$T 1 \left(EB\right) \geq T 1 \left(H\right)$ Equation 1-1

$T 1 \left(EB\right) \geq T 1 \left(D\right)$ Equation 1-2

$T 1 \left(HB\right) > T 1 \left(H\right)$ Equation 1-3

$T 1 \left(HB\right) > T 1 \left(D\right)$ Equation 1-4
wherein, in Equations 1-1 and 1-4,
T1(EB) indicates a lowest excited triplet energy level of the electron blocking material,
T1(HB) indicates a lowest excited triplet energy level of the hole blocking material,
T1(H) indicates a lowest excited triplet energy level of the host, and
T1(D) indicates a lowest excited triplet energy level of the dopant.

In an organic light-emitting device that satisfy Equations 1-1 and 1-2, a ratio of excitons generated in an emission layer that may not participate in emission and move to a hole transport region may be decreased, thus increasing a triplet concentration in the emission layer. Therefore, the organic light-emitting device may have improved efficiency.

In an organic light-emitting device that satisfy Equations 1-3 and 1-4, excitons generated in the emission layer that may not participate in emission and move to an electron transport region may be substantially prevented, thus increasing a triplet concentration in the emission layer. Therefore, the organic light-emitting device may have improved efficiency.

To achieve the aforementioned effects, the emission layer is in direct contact with the hole blocking layer and the electron blocking layer, and another layer may not be interposed between the emission layer and the hole blocking layer and between the emission layer and the electron blocking layer.

In particular, the host, the dopant, and the electron blocking material may satisfy T1(EB)>T1(H) and/or T1(EB)>T1(D), but embodiments are not limited thereto. In this embodiment, excitons generated in the emission layer that may not participate in emission and move to a hole transport region may be substantially prevented, thus increasing a triplet concentration in the emission layer. Therefore, the organic light-emitting device may have significantly improved efficiency.

In particular, the host, the dopant, the electron blocking material, and the hole blocking material may each further satisfy Equation 1-11, Equation 1-21, Equation 1-31, and/or Equation 1-41, but embodiments are not limited thereto:

$1.0 eV \geq T 1 \left(EB\right) - T 1 \left(H\right) \geq 0.01 eV$ Equation 1-11

$1.0 eV \geq T 1 \left(EB\right) - T 1 \left(D\right) \geq 0.01 eV$ Equation 1-21

$1.0 eV \geq T 1 \left(HB\right) - T 1 \left(H\right) \geq 0.01 eV$ Equation 1-31

$1.0 eV \geq T 1 \left(HB\right) - T 1 \left(D\right) \geq 0.01 eV$ Equation 1-41
wherein, in Equations 1-11, 1-21, 1-31, and 1-41,
T1(EB) indicates a lowest excited triplet energy level of the electron blocking material,
T1(HB) indicates a lowest excited triplet energy level of the hole blocking material,
T1(H) indicates a lowest excited triplet energy level of the host, and
T1(D) indicates a lowest excited triplet energy level of the dopant.

In the organic light-emitting device that further satisfies Equations 1-11 and 1-21, as the ratio of triplets that move from the emission layer to the hole blocking layer to triplets that move from the host to the dopant is properly controlled, efficiency and lifespan thereof may be changed simultaneously. In particular, a ratio of triplets that move to the hole blocking layer may be decreased and improving efficiency of the organic light-emitting device.

In the organic light-emitting device that further satisfies Equations 1-31 and 1-41, as the ratio of triplets that move from the emission layer to the electron blocking layer to triplets that move from the host to the dopant is properly controlled, efficiency and lifespan thereof may be changed simultaneously. In particular, a ratio of triplets that move to the electron blocking layer may be decreased and improving efficiency of the organic light-emitting device.

The anode 110 may be formed by depositing or sputtering a material for forming the anode 110 on the substrate. The anode 110 may be selected from materials with a high work function for easy hole injection.

The anode 110 may be a reflective electrode, a semi-transmissive electrode, or a transmissive electrode. When forming a transmissive electrode, a material for forming the anode 110 may be selected from indium tin oxide (ITO), indium zinc oxide (IZO), tin oxide (SnO₂), zinc oxide (ZnO), and any combinations thereof, but embodiments are not limited thereto. In some embodiments, when forming a semi-transmissive electrode or a reflective electrode, as a material for forming the anode, at least one of magnesium (Mg), silver (Ag), aluminum (Al), aluminum-lithium (Al-Li), calcium (Ca), magnesium-indium (Mg-In), magnesium-silver (Mg-Ag), and any combination thereof may be used, but embodiments are not limited thereto.

The anode 110 may have a single-layered structure, or a multi-layered structure including two or more layers. For example, the anode 110 may have a triple-layer structure of ITO/Ag/ITO, but embodiments are not limited thereto.

The organic layer 130 may be on the anode 110. As described, the organic layer 130 may include the emission layer 131 and the first exciton quenching layer 132. The organic layer 130 may further include a hole transport region (not shown) between the anode 110 and the emission layer 131 and an electron transport region (not shown) between the emission layer 131 and the cathode 120.

The hole transport region may have i) a single-layered structure consisting of a single layer consisting of a single material, ii) a single-layered structure consisting of a single layer including a plurality of different materials, or iii) a multi-layered structure having a plurality of layers including a plurality of different materials.

The hole transport region may further include, in addition to the electron blocking layer 132, at least one of a hole injection layer, a hole transport layer, and an emission auxiliary layer.

For example, the hole transport region may have a single-layered structure including a single layer including a plurality of different materials or a multi-layered structure, e.g., a hole injection layer/hole transport layer/electron blocking layer structure, a hole injection layer/hole transport layer/emission auxiliary layer/electron blocking layer structure, a hole injection layer/emission auxiliary layer/electron blocking layer structure, or a hole transport layer/emission auxiliary layer/electron blocking layer structure, wherein layers of each structure are sequentially stacked on the anode 110 in each stated order, but embodiments are not limited thereto.

The hole transport region may include at least one selected from m-MTDATA, TDATA, 2-TNATA, NPB (NPD), β-NPB, TPD, a spiro-TPD, a spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), CzSi, TCTA, a compound represented by Formula 201, and a compound represented by Formula 202: 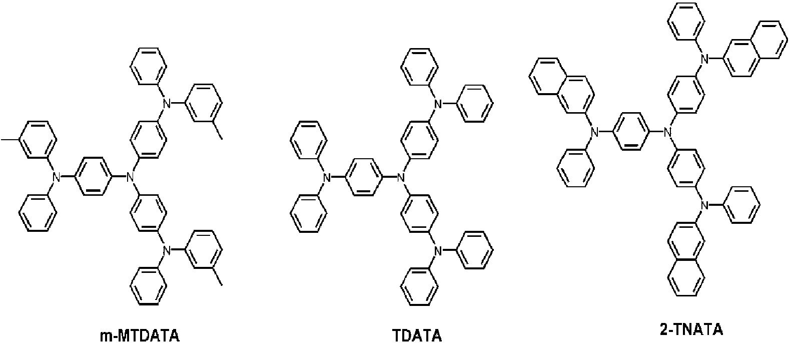 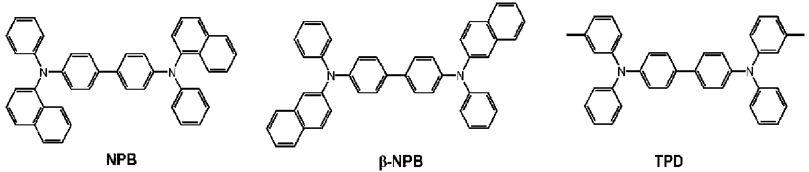 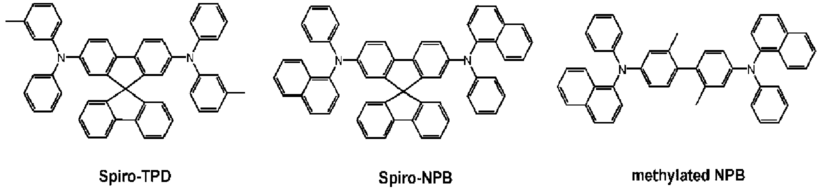 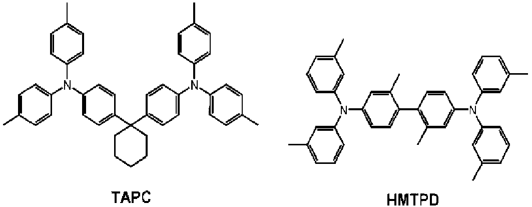 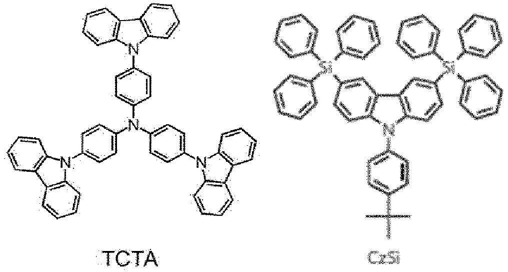 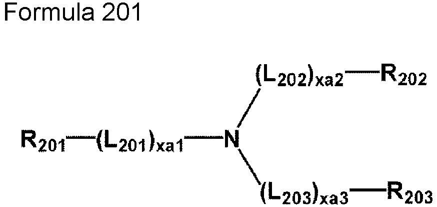 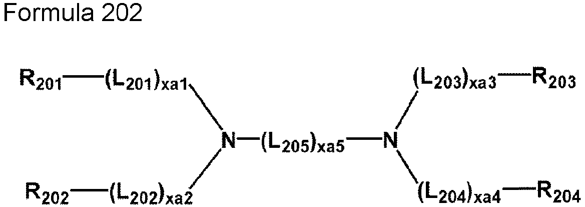 wherein, in Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

In some embodiments, in Formula 202, R₂₀₁ and R₂₀₂ may optionally be bound via a single bond, a dimethyl-methylene group, or a diphenyl-methylene group, and R₂₀₃ and R₂₀₄ may optionally be bound via a single bond, a dimethyl-methylene group, or a diphenyl-methylene group.

In some embodiments, in Formula 201 and 202, L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In some embodiments, xa1 to xa4 may each independently be 0, 1, or 2.

In some embodiments, xa5 may be 1, 2, 3, or 4.

In some embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may respectively be understood by referring to the descriptions of Q₃₁ to Q₃₃ provided herein.

In some embodiments, in Formula 201, at least one of R₂₀₁ to R₂₀₃ may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

In some embodiments, in Formula 202, i) R₂₀₁ and R₂₀₂ may be bound via a single bond, and/or ii) R₂₀₃ and R₂₀₄ may be bound via a single bond.

In some embodiments, in Formula 202, at least one of R₂₀₁ to R₂₀₄ may be selected from:
a carbazolyl group; and
a carbazolyl group substituted with at least one selected from deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

The compound represented by Formula 201 may be represented by Formula 201A:

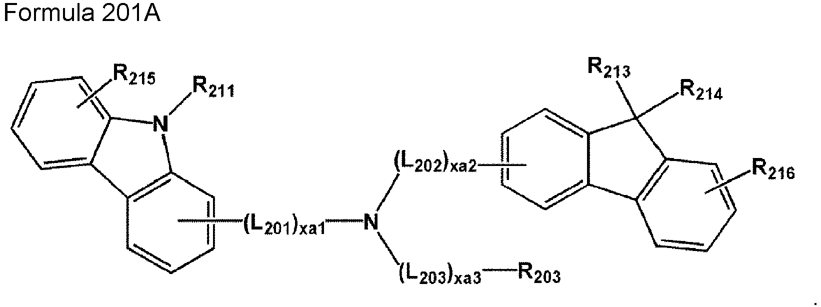

In some embodiments, the compound represented by Formula 201 may be represented by Formula 201A(1), but embodiments are not limited thereto:

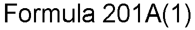

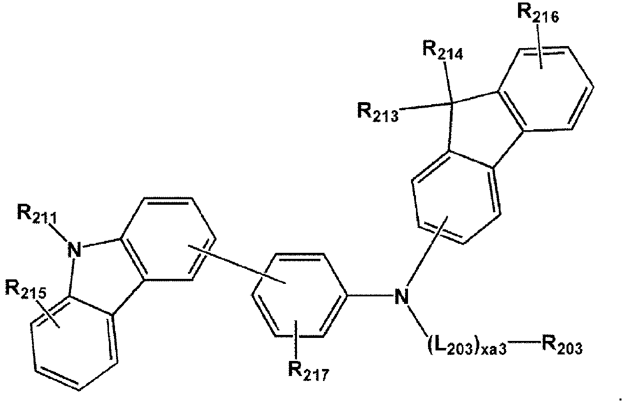

In some embodiments, the compound represented by Formula 201 may be represented by Formula 201A-1, but embodiments are not limited thereto:

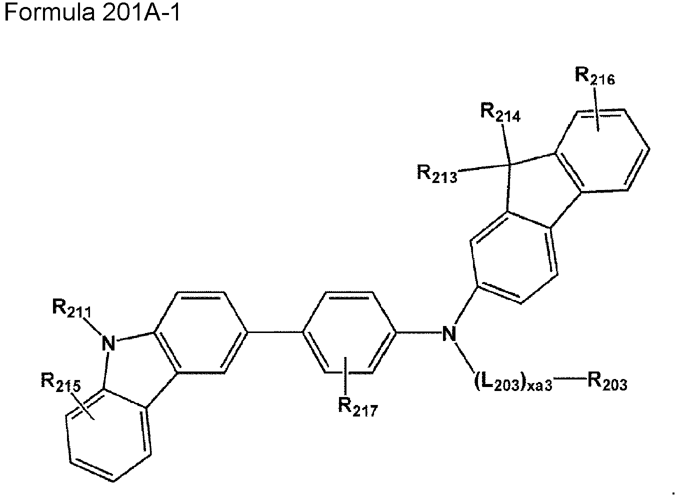

In some embodiments, the compound represented by Formula 202 may be represented by Formula 202A:

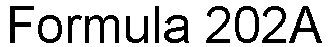

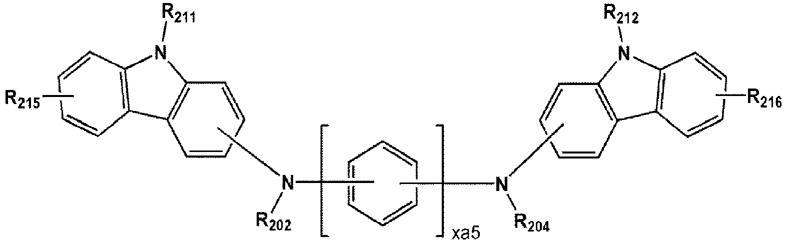

In some embodiments, the compound represented by Formula 202 may be represented by Formula 202A-1:

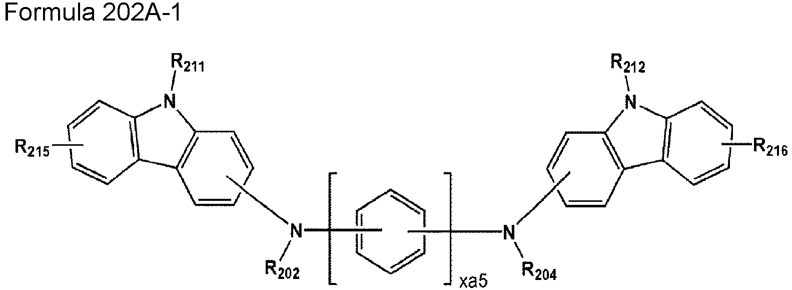

In Formulae 201A, 201A(1), 201A-1, 202A, and 202A-1,
L₂₀₁ to L₂₀₃, xa1 to xa3, xa5, and R₂₀₂ to R₂₀₄ may respectively be understood by referring to the descriptions of L₂₀₁ to L₂₀₃, xa1 to xa3, xa5, and R₂₀₂ to R₂₀₄ provided herein,
R₂₁₁ and R₂₁₂ may each be understood by referring to the description of R₂₀₃ provided herein, and
R₂₁₃ to R₂₁₇ may each independently be selected from hydrogen, deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments are not limited thereto:

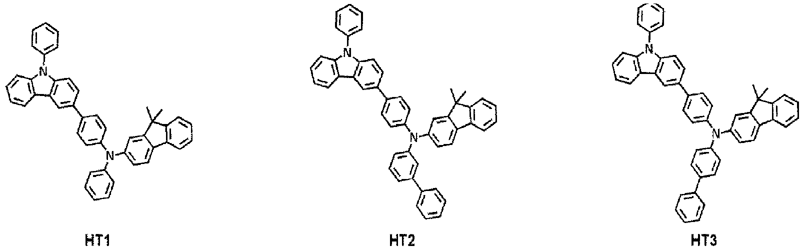

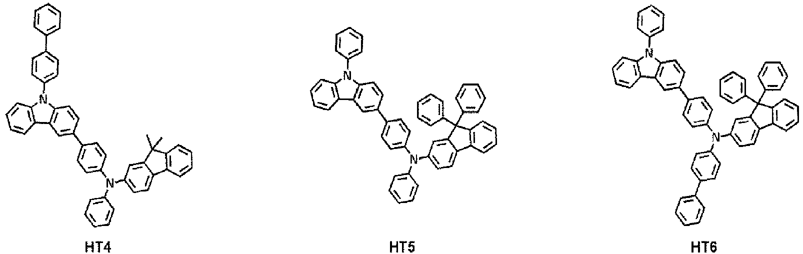

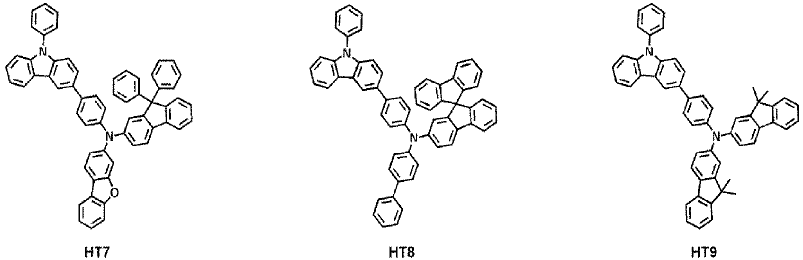

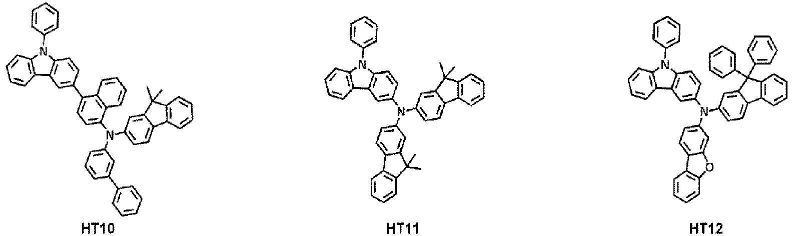

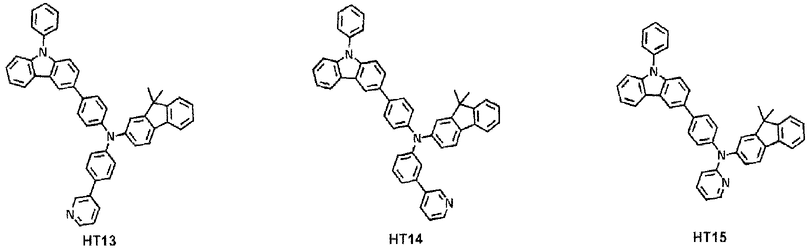

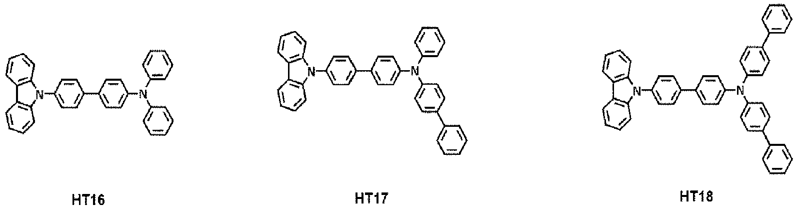

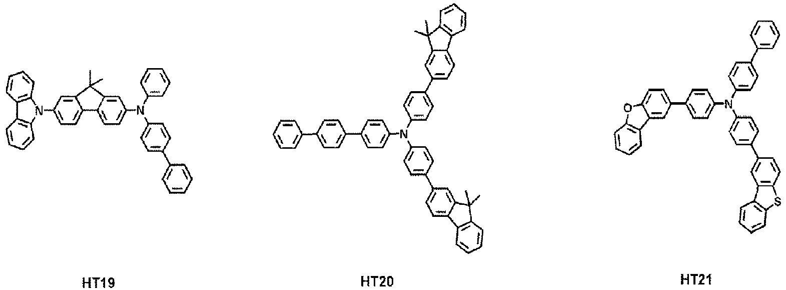

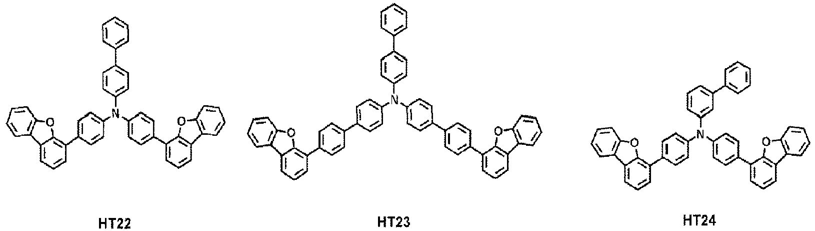

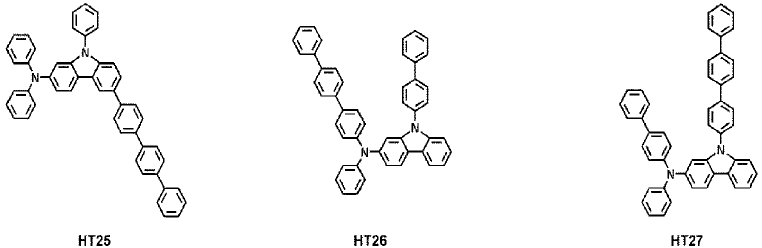

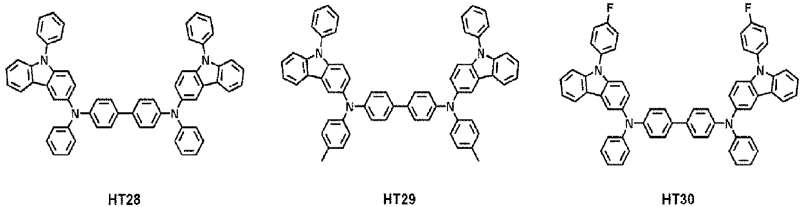

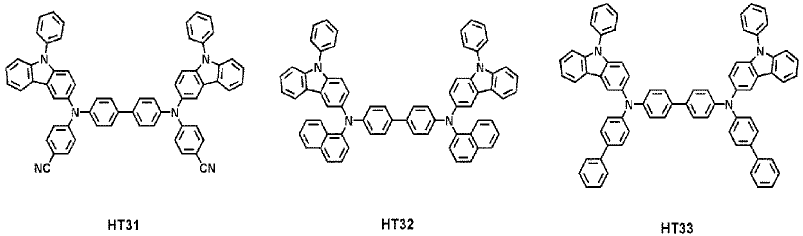

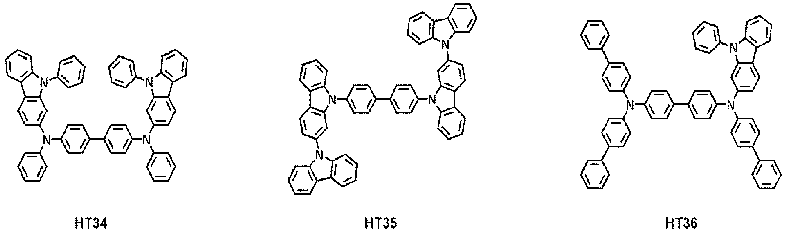

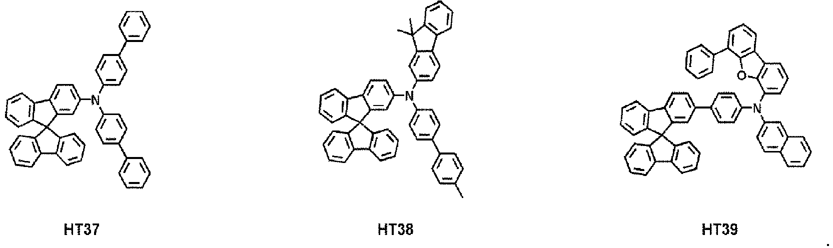

The thickness of the hole transport region may be in a range of 10 - 100 nm [100 - 10,000 Å], and in some embodiments, 10 - 100 nm [100 - 1,000 Å]. When the hole transport region includes at least one of a hole injection layer and a hole transport layer, the thickness of the hole injection layer may be in a range of 10 - 900 nm [100 - 9,000 Å], and in some embodiments, 10 - 100 nm [100 - 1,000 Å], and the thickness of the hole transport layer may be in a range of 10 - 100 nm [50 - 2,000 Å], and in some embodiments, 10 - 150 nm [100 - 1,500 Å]. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant.

In some embodiments, a lowest unoccupied molecular orbital (LUMO) of the p-dopant may be -3.5 eV or less.

The p-dopant may include at least one selected from a quinone derivative, a metal oxide, and a cyano group-containing compound, but embodiments are not limited thereto.

In some embodiments, the p-dopant may be selected from a quinone derivative, such as tetracyanoquinodimethane (TCNQ) or 2,3,5,6-tetrafluoro-7,7,8,8-tetracyanoquinodimethane (F4-TCNQ);
a metal oxide, such as tungsten oxide or molybdenum oxide;
1,4,5,8,9,11-hexaazatriphenylene-hexacarbonitrile (HAT-CN); and
a compound represented by Formula 221, but embodiments are not limited thereto: 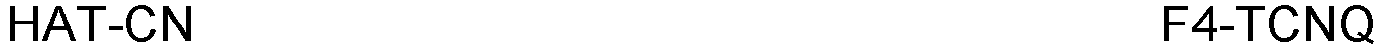 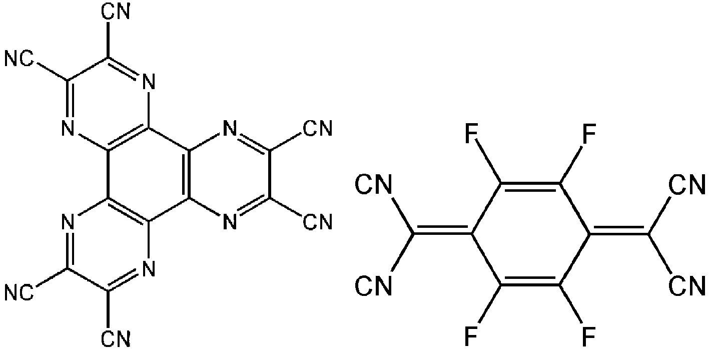 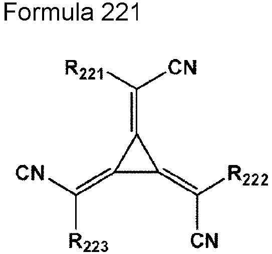
wherein, in Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, wherein at least one of R₂₂₁ to R₂₂₃ may include at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

The electron blocking material may satisfy 2.5 eV≤T1(EB)≤3.5 eV, but embodiments are not limited thereto. When the range described above is satisfied, excitons may be substantially confined in the emission layer, thus allowing excitons to sufficiently participate in emission.

The electron blocking material may include, e.g., a carbazole-based derivative such as N-phenylcarbazole or polyvinylcarbazole, a fluorine-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalene-l-yl)-N,N'-diplienyl-benzidine (NPD), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), or mCP.

In particular, the electron blocking material may include a compound represented by Formula 1, but embodiments are not limited thereto:

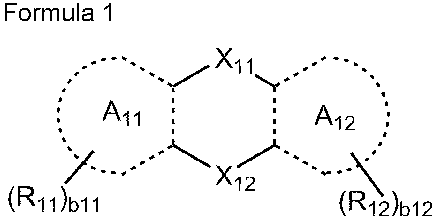

wherein, in Formula 1,
X₁₁ may be selected from O, S, N(R₁₃), and C(R₁₃)(R₁₄),
X₁₂ may be selected from a single bond, O, S, N(R₁₅), and C(R₁₅)(R₁₆),
A₁₁ and A₁₂ may each independently be selected from a C₅-C₆₀ carbocyclic group and a C₁-C₆₀ heterocyclic group,
R₁₁ to R₁₆ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂),
b11 and b12 may each independently be selected from 1, 2, 3, 4, 5, and 6,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a biphenyl group, and a terphenyl group.

In particular, the electron blocking material may be selected from Compounds 1 to 12, but embodiments are not limited thereto:

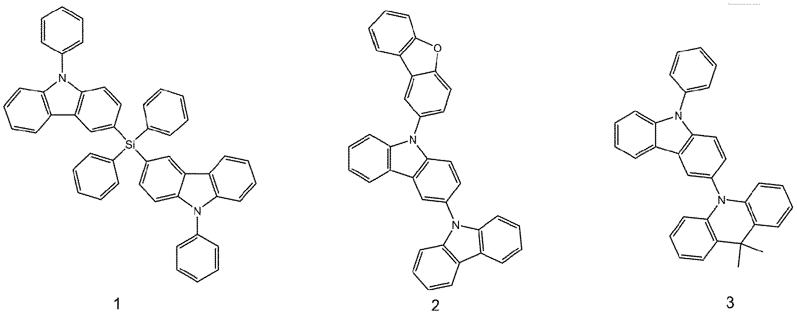

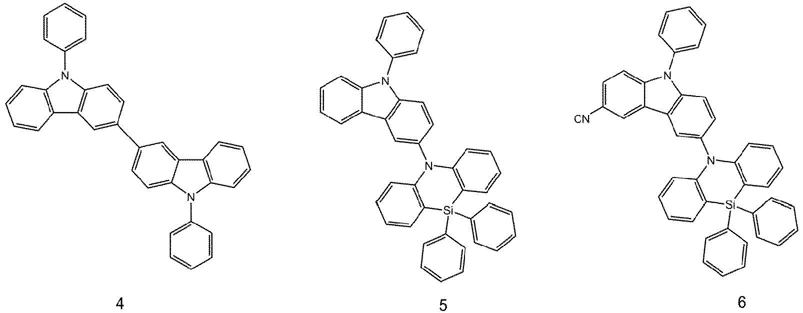

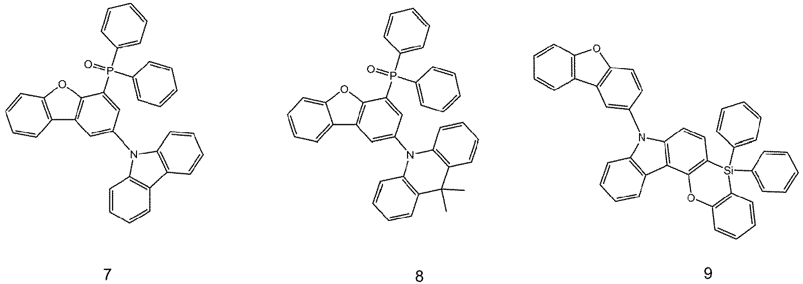

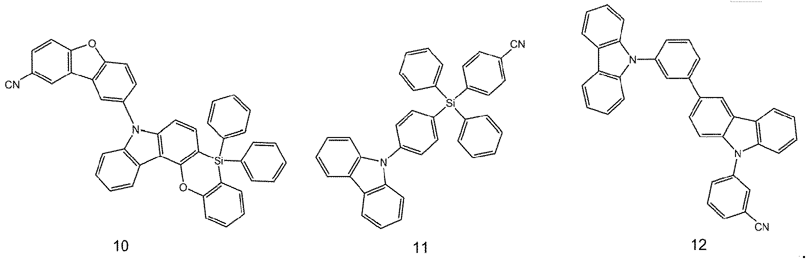

The electron blocking layer may consist of a single compound or a mixture including at least two different compounds.

In some embodiments, the electron blocking material may be identical to the host, but embodiments are not limited thereto. For example, the electron blocking material may be identical to the hole transporting host, but embodiments are not limited thereto.

In some embodiments, a thickness (D_{E}) of the emission layer 131 ≥ a thickness (D_{EB}) of the electron blocking layer 132. In particular, a thickness (D_{E}) of the emission layer 131 > a thickness (D_{EB}) of the electron blocking layer 132, but embodiments are not limited thereto. When the range described above is satisfied, the organic light-emitting device may have improved efficiency while not increasing the driving voltage.

In some embodiments, a thickness of the electron blocking layer 132 may be in a range of 1 - 20 nm [10 - 200 Å], but embodiments are not limited thereto. When the range described above is satisfied, the organic light-emitting device may have improved efficiency while not substantially increasing the driving voltage.

In some embodiments, the organic layer 130 may include a hole transport layer located between the anode 110 and the electron blocking layer 132, wherein the hole transport layer may include a hole transporting material, and the host and the hole transporting material may each satisfy Equation 6:$T 1 \left(H\right) \geq T 1 \left(HT\right)$ Equation 6 wherein, in Equation 6,
T1(H) indicates a lowest excited triplet energy level of the host, and
T1(HT) indicates a lowest excited triplet energy level of the hole transporting material.

When Equation 6 is satisfied, an organic light-emitting device may have further improved efficiency.

The emission layer 131 includes a host and a dopant.

In some embodiments, the host may satisfy T1(H)≥T1(D), but embodiments are not limited thereto. When the host satisfies this range, excitons may move from the host to the dopant smoothly.

The host comprises the first host and the second host, the first host may be selected from Compounds 1 to 12 (compounds represented by Formula 1) and the second host may be selected by compounds 21 to 27 (compounds represented by Formula 2), but embodiments are not limited thereto:

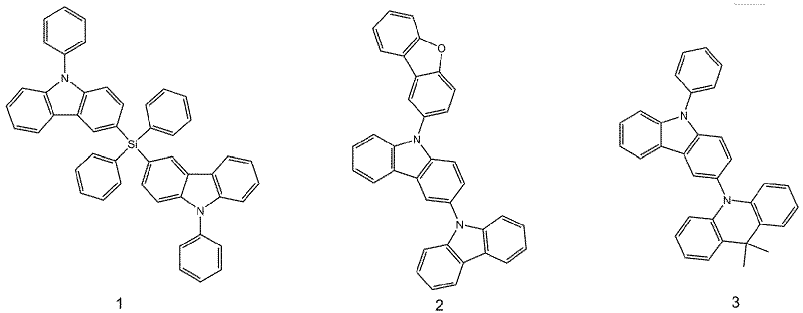

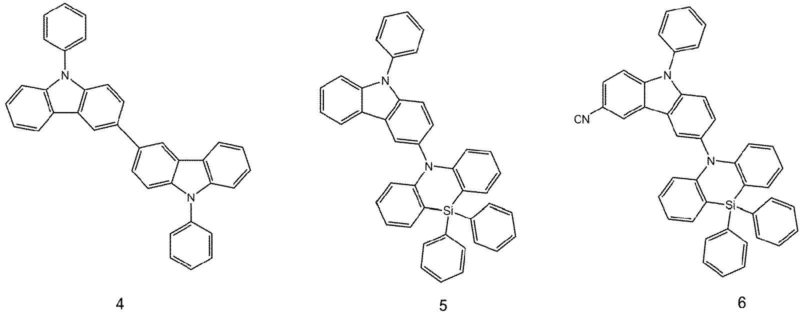

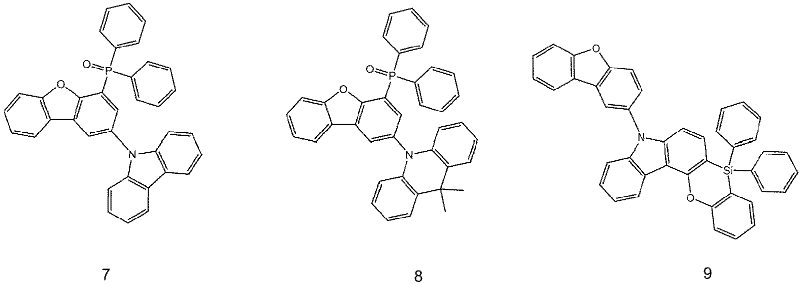

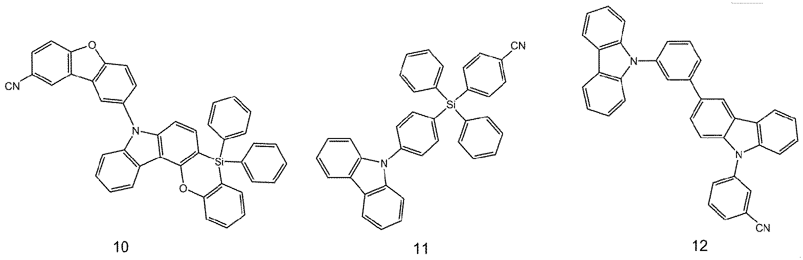

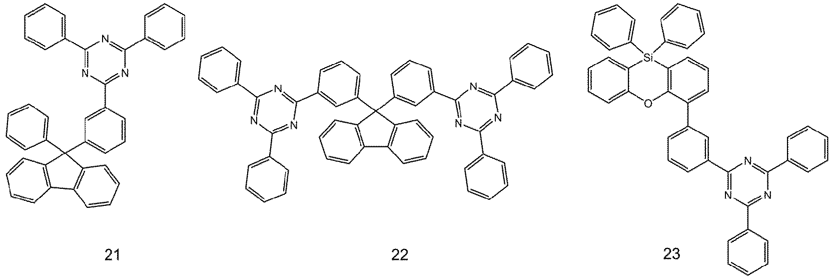

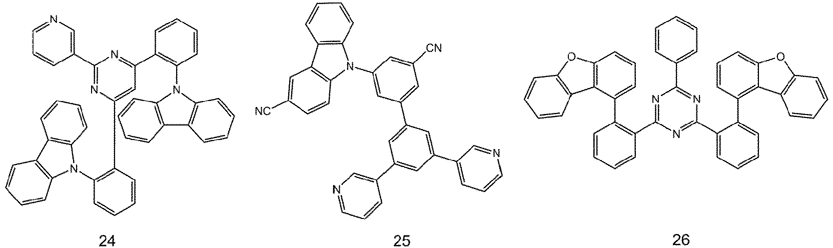

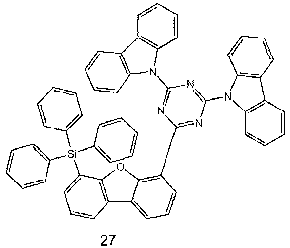

The host includes the first host and the second host.

According to one or more embodiments, the first host may be a hole transporting host not including an electron transporting moiety, and the second host may be an electron transporting host including at least one electron transporting moiety, but embodiments are not limited thereto.

The term "electron transporting moiety", as used herein, may include a cyano group, a phosphine oxide group, a sulfone oxide group, a sulfonate group, and/or a π electron-depleted nitrogen-containing ring. The first host is represented by Formula 1, and the second host is represented by Formula 2.

In some embodiments, the first host may be selected from Compounds 1 to 12, and the second host may be selected from Compounds 21 to 27, but embodiments are not limited thereto.

In some embodiments, the first host may be identical to the electron blocking material, but embodiments are not limited thereto.

In some embodiments, the second host may be identical to the hole blocking material, but embodiments are not limited thereto.

The dopant may emit thermal activated delayed fluorescence or fluorescence.

In some embodiments, the dopant may satisfy Equation 3:

$\left|S1\left(D\right)-T1\left(D\right)\right| \leq 0.5 eV$ Equation 3
wherein, in Equation 3,
T1(D) indicates a lowest excited triplet energy level of the dopant, and
S1(D) indicates a lowest excited singlet energy level of the dopant.

When Equation 3 is satisfied, thermal activated delayed fluorescence may be emitted even at room temperature.

In particular, |S1(D)-T1(D)|≤0.2 eV may be satisfied, but embodiments are not limited thereto.

In some embodiments, the dopant may satisfy Equation 4 and/or Equation 5, but embodiments are not limited thereto:

$2.65 eV \leq S 1 \left(D\right) \leq 2.85 eV$ Equation 4
$2.65 eV \leq T 1 \left(D\right) \leq 3.05 eV$ Equation 5
wherein, in Equations 4 and 5,
T1(D) indicates a lowest excited triplet energy level of the dopant, and
S1(D) indicates a lowest excited singlet energy level of the dopant.

When Equation 4 and/or Equation 5 is satisfied, the dopant may emit blue light.

In some embodiments, the dopant may not include a metal atom. That is, the dopant is different from a phosphorescence-emitting emitter including a metal atom.

For example, the dopant may have a D-shape structure including an electron-donating group (D) and an electron-accepting group (A). In particular, the dopant may be a compound described in Japanese Application Publication No. 2011-140046, Japanese Application Publication No. 2013-034967, Japanese Application Publication No. 2015-530745, Japanese Application Publication No. 2013-034967, Japanese Application Publication No. 2014-512416, Japanese Application Publication No. 2015-525248, Japanese Application Publication No. 2013-524707, Japanese Application Publication No. 2013-547225, Japanese Application Publication No. 2012-274324, Japanese Application Publication No. 2015-504322, U.S. Patent Publication No. 2012-0217869, WO 2015-118035, WO 2016-091887, WO 2016-096851, Korean Application Publication 10-2017-7005332, Japanese Application Publication No. 2014-518737, U.S. Patent Publication No. 2016-0197286, U.S. Patent Publication No. 2014-0138627, U.S. Patent Publication No. 2014-0145149, U.S. Patent Publication No. 2014-0158992, U.S. Patent Publication No. 2014-0145151, U.S. Patent Publication No. 2015-0021555, U.S. Patent Publication No. 2014-0332758, Korean Application Publication 10-2014-0154391, Japanese Application Publication No. 2015-148588, Japanese Application Publication No. 2016-506442, Japanese Application Publication No. 2015-531748, Japanese Application Publication No. 2016-538300, Japanese Application Publication No. 2016-538393, Japanese Application Publication No. 2015-095814, Japanese Application Publication No. 2012-538639, Japanese Application Publication No. 2014-525803, Japanese Application Publication No. 2012-546858, Japanese Application Publication No. 2016-538300, or Japanese Application Publication No. 2014-538540, but embodiments are not limited thereto.

In some embodiments, the dopant may have a D-A-D shape structure or an A-D shape structure. In particular, the dopant may be a compound described in WO 2015-158692, Japanese Application Publication No. 2016-538435, Japanese Application Publication No. 2016-538426, Japanese Application Publication No. 2015-500308, or Japanese Application Publication No. 2015-527231, but embodiments are not limited thereto.

In some embodiments, the dopant may be a transition metal complex. In particular, the dopant may be a Cu complex or a Pt complex, and the dopant may be a compound described in Korean Application Publication 10-2012-7017497, Korean Application Publication 10-2013-7001396, Korean Application Publication 10-2014-0068027, Korean Application Publication 10-2014-7003327, or U.S. Patent Publication No. 2011-0304262, but embodiments are not limited thereto.

In some embodiments, the dopant may be a compound including a B-N structure, and the dopant may be a compound described in U.S. Patent Publication No. 2014-0027734, but embodiments are not limited thereto.

In some embodiments, the dopant may be a compound described in Japanese Application Publication No. 2015-508569 or Japanese Application Publication No. 2014-554306, but embodiments are not limited thereto.

The electron-donating group (D) may be, for example, a carbazole group, a dibenzothiophene group, a dibenzofuran group, an indolocarbazole group, or a biscarbazole group, but embodiments are not limited thereto.

The electron-accepting group (A) may be an aryl group substituted with CN, F, CN, and/or F or a π electron-depleted nitrogen-containing cyclic group, but embodiments are not limited thereto.

A content of the dopant in the emission layer may be in a range of about 0.01 percent by volume (vol%) to about 50 vol%, but embodiments are not limited thereto. In some embodiments, a content of the dopant in the emission layer may be about 0.1 vol% or greater or about 30 vol% or less, but embodiments are not limited thereto.

The thickness of the emission layer 131 may be in a range of 10 - 100 nm [100 - 1,000 Å], and in some embodiments, 20 -60 nm [200 - 600 Å]. When the thickness of the emission layer is within any of these ranges, improved luminescence characteristics may be obtained without a substantial increase in driving voltage.

The electron transport region may have i) a single-layered structure consisting of a single layer consisting of a single material, ii) a single-layered structure consisting of a single layer including a plurality of different materials, or iii) a multi-layered structure each having a plurality of layers, each having a plurality of different materials.

The electron transport region may include, in addition to a hole blocking layer, at least one selected from a buffer layer, an electron control layer, an electron transport layer, and an electron injection layer, but embodiments are not limited thereto.

In some embodiments, the electron transport region may have a hole blocking layer/electron transport layer/electron injection layer structure, a hole blocking layer/electron control layer/electron transport layer/electron injection layer structure, or a hole blocking layer/buffer layer/electron transport layer/electron injection layer structure, wherein layers of each structure are sequentially stacked on the emission layer in each stated order, but embodiments are not limited thereto.

The hole blocking material may satisfy 2.5 eV≤T1(HB)≤3.5 eV, but embodiments are not limited thereto. When the range described above is satisfied, excitons may be substantially confined in the emission layer, thus allowing excitons in the emission layer to sufficiently participate in emission.

The hole blocking material may be represented by Formula 2, but embodiments are not limited thereto:

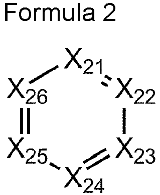

wherein, in Formula 2,
X₂₁ may be N or C(R₂₁), X₂₂ may be N or C(R₂₂), X₂₃ may be N or C(R₂₃), X₂₄ may be N or C(R₂₄), X₂₅ may be N or C(R₂₅), and X₂₆ may be N or C(R₂₆), provided that at least one of X₂₁ to X₂₆ may be N,
R₂₁ to R₂₆ may each independently be selected from hydrogen, deuterium, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
at least one of R₂₁ to R₂₆ may be selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

In some embodiments, the hole blocking material may be selected from Compounds 21 to 27, but embodiments are not limited thereto:

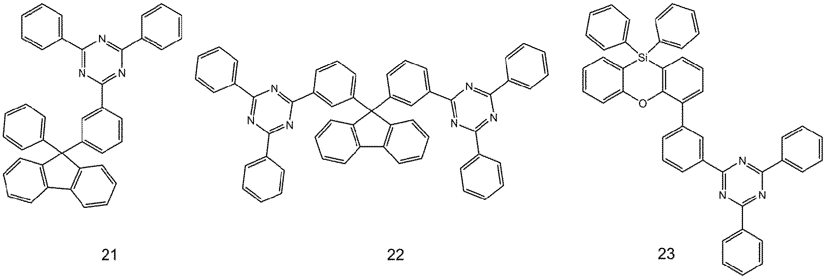

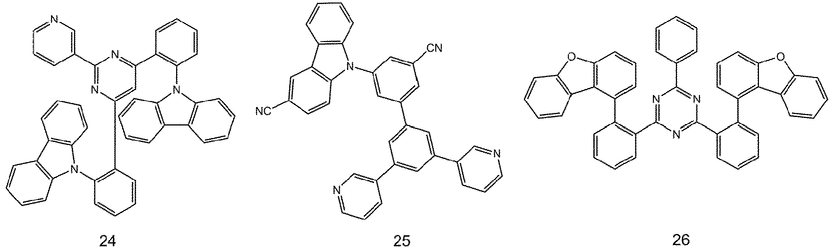

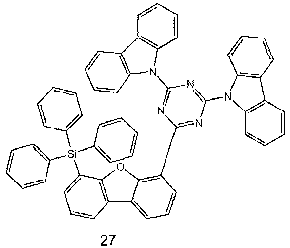

The hole blocking layer may consist of a single compound or a mixture including at least two different compounds.

In some embodiments, the hole blocking material may be identical to the host, but embodiments are not limited thereto. For example, the hole blocking material may be identical to the electron transporting host, but embodiments are not limited thereto.

In some embodiments, a thickness (D_{E}) of the emission layer 131 ≥ a thickness (D_{HB}) of the hole blocking layer 133. In particular, a thickness (D_{E}) of the emission layer 131 > a thickness (D_{HB}) of the hole blocking layer 133, but embodiments are not limited thereto. When the range described above is satisfied, the organic light-emitting device may have improved efficiency while not increasing the driving voltage.

In some embodiments, a thickness of the hole blocking layer 133 may be in a range of 1 20 nm [10 - 200 Å], but embodiments are not limited thereto. When the range described above is satisfied, the organic light-emitting device may have improved efficiency while not substantially increasing the driving voltage.

In the invention, the organic layer 130 includes an electron transport layer located between the cathode 120 and the hole blocking layer 133, wherein the electron transport layer includes an electron transporting material, and the dopant and the electron transporting material each satisfy Equation 7:

$T 1 \left(D\right) \geq T 1 \left(ET\right)$ Equation 7
wherein, in Equation 7,
T1(D) indicates a lowest excited triplet energy level of the dopant, and
T1(ET) indicates a lowest excited triplet energy level of the electron transporting material.

The electron transport region (for example, the buffer layer, the electron control layer, or the electron transport layer in the electron transport region) may include a metal-free compound including at least one π electron-depleted nitrogen-containing ring.

The term "π electron-depleted nitrogen-containing ring" as used herein refers to a C₁-C₆₀ heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which at least two 5-membered to 7-membered heteromonocyclic groups, each having at least one *-N=*' moiety, are condensed, or iii) a heteropolycyclic group in which at least one of a 5-membered to 7-membered heteromonocyclic group, each having at least one *-N=*' moiety, is condensed with at least one C₅-C₆₀ carbocyclic group.

Examples of the π electron-depleted nitrogen-containing ring may include imidazole, pyrazole, thiazole, isothiazole, oxazole, isoxazole, pyridine, pyrazine, pyrimidine, pyridazine, indazole, purine, quinoline, isoquinoline, benzoquinoline, phthalazine, naphthyridine, quinoxaline, quinazoline, cinnoline, phenanthridine, acridine, phenanthroline, phenazine, benzimidazole, isobenzothiazole, benzoxazole, isobenzoxazole, triazole, tetrazole, oxadiazole, triazine, thiadiazole, imidazopyridine, imidazopyrimidine, and azacarbazole, but embodiments are not limited thereto.

In some embodiments, the electron transport region may include a compound represented by Formula 601:

${\left[{Ar}_{601}\right]}_{xe 11} - {\left[{\left({L}_{601}\right)}_{xe 1}-{R}_{601}\right]}_{xe 21}$ Formula 601
wherein, in Formula 601,
Ar₆₀₁ may be selected from a substituted or unsubstituted C₅-C₆₀ carbocyclic group and a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
wherein Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In an embodiment, at least one of Ar₆₀₁(s) in the number of xe11 and R₆₀₁(s) in the number of xe21 may include the π electron-depleted nitrogen-containing ring.

In some embodiments, in Formula 601, Ar₆₀₁ may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or greater, at least two Ar₆₀₁(s) may be bound via a single bond.

In one or more embodiments, Ar₆₀₁ in Formula 601 may be an anthracene group.

In one or more embodiments, a compound represented by Formula 601 may be represented by Formula 601-1:

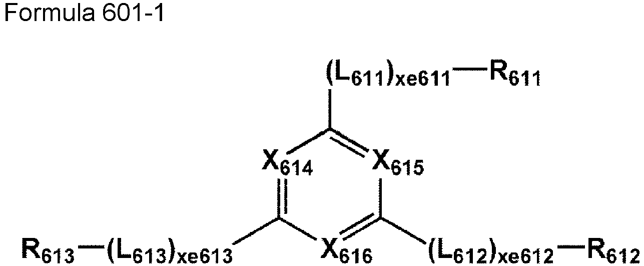

wherein, in Formula 601-1,
X₆₁₄ may be N or C(R₆₁₄), X₆₁₅ may be N or C(R₆₁₅), X₆₁₆ may be N or C(R₆₁₆), at least one of X₆₁₄ to X₆₁₆ may be N,
L₆₁₁ to L₆₁₃ may each independently be understood by referring to the description of L₆₀₁ provided herein,
xe611 to xe613 may each independently be understood by referring to the description of xe1 provided herein,
R₆₁₁ to R₆₁₃ may each independently be understood by referring to the description of R₆₀₁ provided herein, and
R₆₁₄ to R₆₁₆ may each independently be selected from hydrogen, deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In an embodiment, in Formulae 601 and 601-1, L₆₀₁ and L₆₁₁ to L₆₁₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments are not limited thereto.

In one or more embodiments, xe1 and xe611 to xe613 in Formulae 601 and 601-1 may each independently be 0, 1, or 2.

In one embodiment, in Formulae 601 and 601-1, R₆₀₁ and R₆₁₁ to R₆₁₃ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may respectively be understood by referring to the descriptions of Q₆₀₁ and Q₆₀₂ provided herein.

The electron transport region may include at least one compound selected from Compounds ET1 to ET36, but embodiments are not limited thereto:

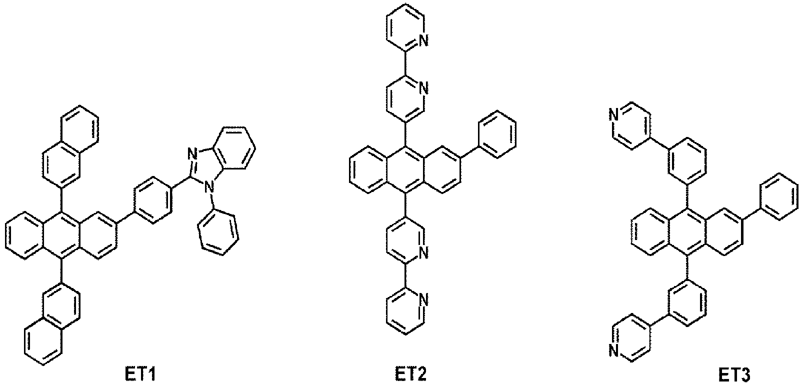

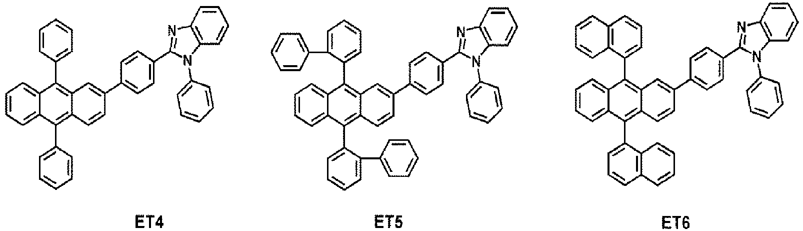

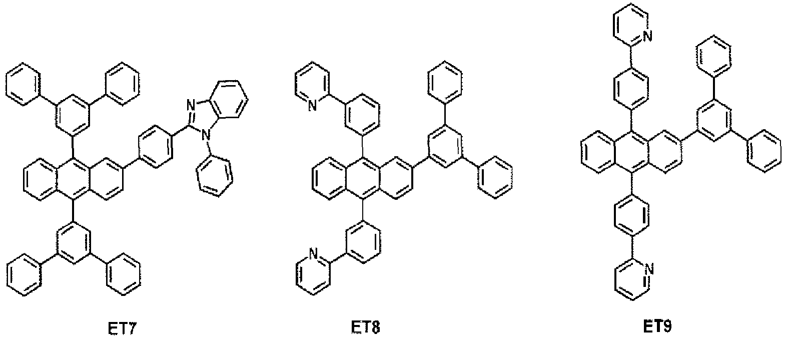

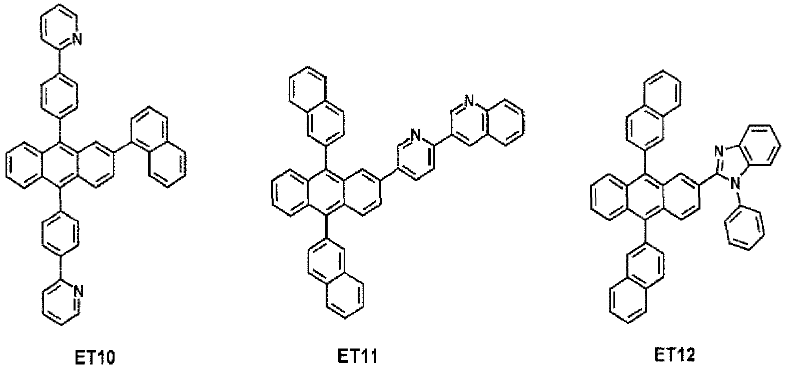

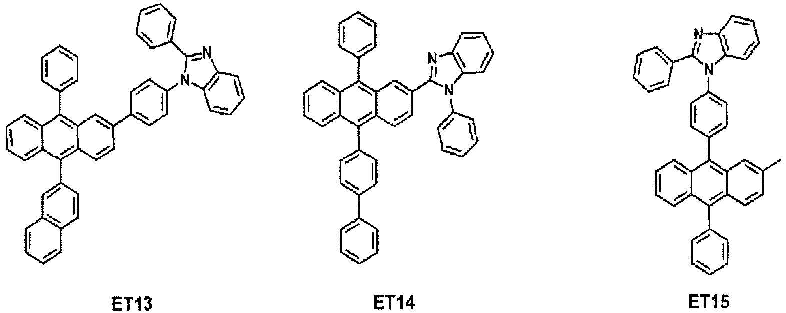

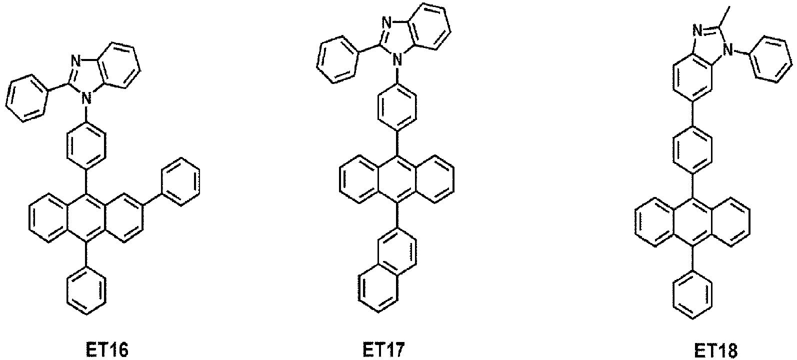

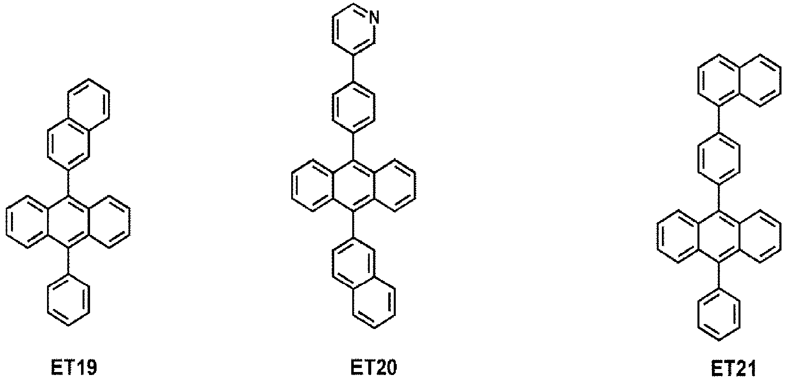

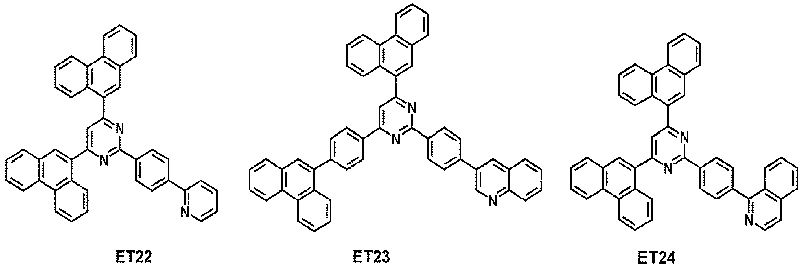

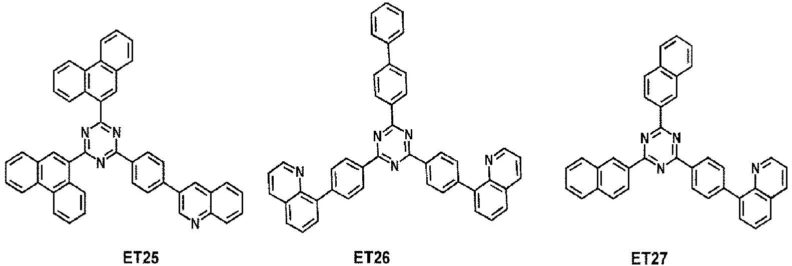

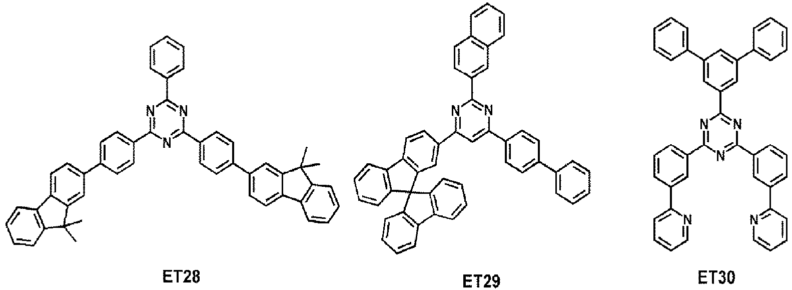

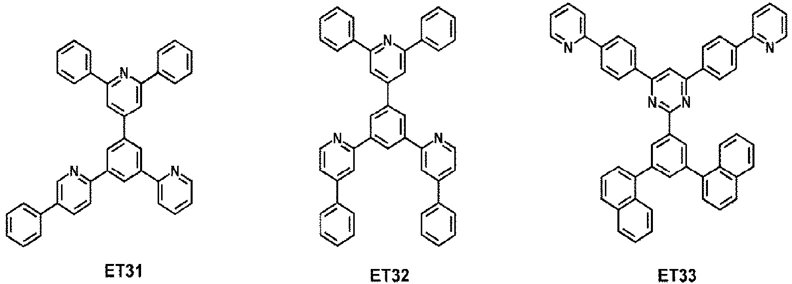

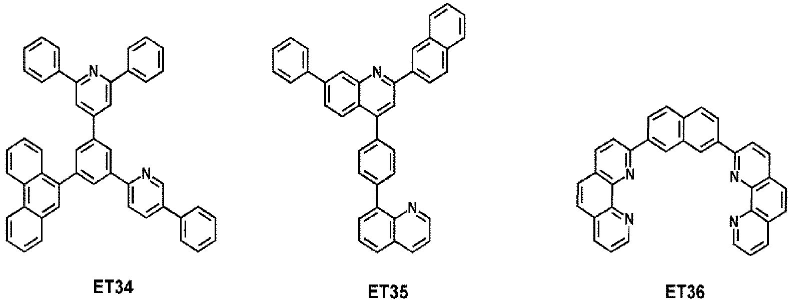

In some embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), NTAZ, diphenyl[4-(triphenylsilyl)phenyl]phosphine oxide *(TSPO1), 2,2',2"-(1,3,5-benzinetriyl)-tris(1-phenyl-1-H-benzimidazole) (TPBi), and diphenylphosphine oxide (DPEPO):

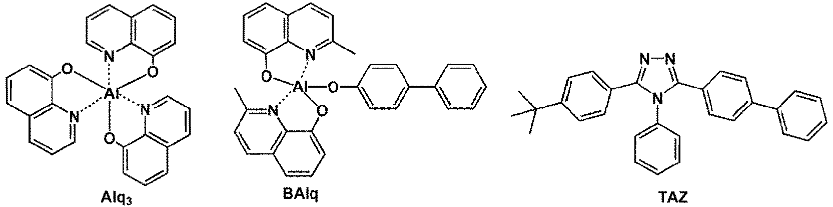

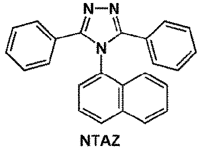

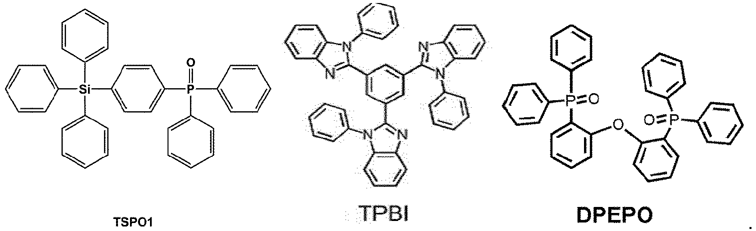

The thicknesses of the buffer layer, the hole blocking layer, or the electron control layer may each independently be in a range of about 20 Å to about 1,000 Å, and in some embodiments, about 30 Å to about 300 Å. When the thicknesses of the buffer layer, the hole blocking layer or the electron control layer are within any of these ranges, excellent hole blocking characteristics or excellent electron controlling characteristics may be obtained without a substantial increase in driving voltage.

The thickness of the electron transport layer may be in a range of 10 - 100 nm [100 - 1,000 Å], and in some embodiments, 15 - 50 nm [150 - 500 Å].When the thickness of the electron transport layer is within any of these ranges, excellent electron transport characteristics may be obtained without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth metal complex. The alkali metal complex may include a metal ion selected from a lithium (Li) ion, a sodium (Na) ion, a potassium (K) ion, a rubidium (Rb) ion, and a cesium (Cs) ion. The alkaline earth metal complex may include a metal ion selected from a beryllium (Be) ion, a magnesium (Mg) ion, a calcium (Ca) ion, a strontium (Sr) ion, and a barium (Ba) ion. Each ligand coordinated with the metal ion of the alkali metal complex and the alkaline earth metal complex may independently be selected from hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, and cyclopentadiene, but embodiments are not limited thereto.

For example, the metal-containing material may include a Li complex. The Li complex may include, e.g., Compound ET-D1 (LiQ) or Compound ET-D2:

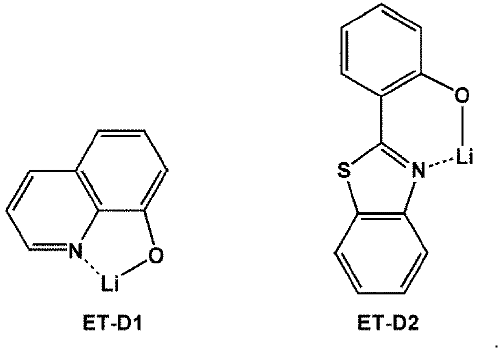

The electron transport region may include an electron injection layer that facilitates injection of electrons from the cathode 120. The electron injection layer may be in direct contact with the cathode 120.

The electron injection layer may have i) a single-layered structure consisting of a single layer consisting of a single material, ii) a single-layered structure consisting of a single layer including a plurality of different materials, or iii) a multi-layered structure having a plurality of layers, each including a plurality of different materials.

The electron injection layer may include an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The alkali metal may be selected from Li, Na, K, Rb, and Cs. In some embodiments, the alkali metal may be Li, Na, or Cs. In one or more embodiments, the alkaline metal may be Li or Cs, but is not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth metal compound, and the rare earth metal compound may each independently be selected from oxides and halides (e.g., fluorides, chlorides, bromides, or iodines) of the alkali metal, the alkaline earth metal, and the rare earth metal, respectively.

The alkali metal compound may be selected from alkali metal oxides, such as Li₂O, Cs₂O, or K₂O, and alkali metal halides, such as LiF, NaF, CsF, KF, Lil, Nal, CsI, KI, or RbI. In an embodiment, the alkali metal compound may be selected from LiF, Li₂O, NaF, Lil, Nal, CsI, and KI, but embodiments are not limited thereto.

The alkaline earth-metal compound may be selected from alkaline earth-metal compounds, such as BaO, SrO, CaO, BaₓSr₁₋ₓO (wherein 0<x<1), and BaₓCa₁₋ₓO (wherein 0<x<1). In an embodiment, the alkaline earth metal compound may be selected from BaO, SrO, and CaO, but embodiments are not limited thereto.

The rare earth metal compound may be selected from YbF₃, ScF₃, ScO₃, Y₂O₃, Ce₂O₃, GdF₃, and TbF₃. In some embodiments, the rare earth metal compound may be selected from YbF₃, ScF₃, TbF₃, YbI₃, ScI₃, and TbI₃, but embodiments are not limited thereto.

The alkali metal complex, the alkaline earth metal complex, and the rare earth metal complex may each include ions of the above-described alkali metal, alkaline earth metal, and rare earth metal. Each ligand coordinated with the metal ion of the alkali metal complex, the alkaline earth metal complex, and the rare earth metal complex may independently be selected from hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, and cyclopentadiene, but embodiments are not limited thereto.

The electron injection layer may consist of an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In some embodiments, the electron injection layer may further include an organic material. When the electron injection layer further includes an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof may be homogeneously or non-homogeneously dispersed in a matrix including the organic material.

The thickness of the electron injection layer may be in a range of 0,1 - 10 nm [1 - 100 Å], and in some embodiments, 0,3 - 9 nm [3 Å - 90 Å]. When the thickness of the electron injection layer is within any of these ranges, excellent electron injection characteristics may be obtained without a substantial increase in driving voltage.

The cathode 120 may be on the organic layer 130. A material for forming the cathode 120 may be a material with a low work function, such as a metal, an alloy, an electrically conductive compound, and a combination thereof.

The cathode 120 may include at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments are not limited thereto. The cathode 120 may be a transmissive electrode, a semi-transmissive electrode, or a reflective electrode.

The cathode 120 may have a single-layered structure, or a multi-layered structure including two or more layers.

In FIG. 1, a substrate may be additionally disposed under (a surface not in contact with the organic layer) the anode 110 or on (a surface not in contact with the organic layer) of the cathode 120. The substrate may be a glass substrate or a plastic substrate, each having excellent mechanical strength, thermal stability, transparency, surface smoothness, ease of handling, and water resistance.

When the organic light-emitting device 1 is a full color organic light-emitting device, the emission layer 131 may be patterned into a red emission layer, a green emission layer, or a blue emission layer, according to a sub-pixel. In one or more embodiments, the emission layer 131 may have a stacked structure. The stacked structure may include two or more layers selected from a red emission layer, a green emission layer, and a blue emission layer. The two or more layers may be in direct contact with each other. In some embodiments, the two or more layers may be separated from each other. In one or more embodiments, the emission layer may include two or more materials. The two or more materials may include a red light-emitting material, a green light-emitting material, or a blue light-emitting material. The two or more materials may be mixed with each other in a single layer. The two or more materials mixed with each other in the single layer may emit white light.

The organic light-emitting device 1 may further include a capping layer in a direction to which light is passed. The capping layer may improve the external luminescence efficiency based on the principle of constructive interference.

The capping layer may each independently be a capping layer consisting of an organic material, an inorganic capping layer consisting of an inorganic material, or a composite capping layer including an organic material and an inorganic material.

The capping layer may include at least one material of carbocyclic compounds, heterocyclic compounds, amine-based compounds, porphine derivatives, phthalocyanine derivatives, naphthalocyanine derivatives, alkali metal complexes, and alkaline earth metal complexes. The carbocyclic compound, the heterocyclic compound, and the amine group-containing compound may optionally be substituted with a substituent containing at least one element selected from O, N, S, Se, Si, F, Cl, Br, and I.

In some embodiments, the capping layer may include at least one amine-based compound.

In some embodiments, the capping layer may include the compound represented by Formula 201 or the compound represented by Formula 202.

In some embodiments, the capping layer may include a compound selected from Compounds HT28 to HT33 and Compounds CP1 to CP5, but embodiments are not limited thereto:

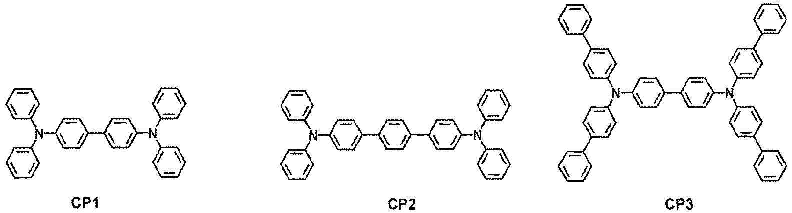

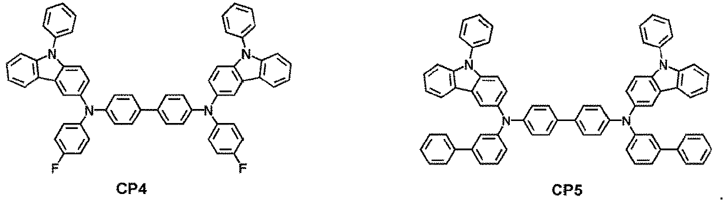

Hereinbefore the organic light-emitting device 10 has been described with reference to FIG. 1, but embodiments are not limited thereto.

The layers constituting the hole transport region, the emission layer, and the layers constituting the electron transport region may be formed in a specific region by using one or more suitable methods such as vacuum deposition, spin coating, casting, Langmuir-Blodgett (LB) deposition, ink-jet printing, laser printing, and laser-induced thermal imaging.

When the layers constituting the hole transport region, the emission layer, and the layers constituting the electron transport region are each formed by vacuum deposition, the vacuum deposition may be performed at a deposition temperature in a range of about 100 °C to about 500 °C at a vacuum degree in a range of about 10⁻⁸ torr to about 10⁻³ torr, and at a deposition rate in a range of 0,001 - 10 nm/s [0.01 - 100 Å], depending on the material to be included in each layer and the structure of each layer to be formed.

When the layers constituting the hole transport region, the emission layer, and the layers constituting the electron transport region are each formed by spin coating, the spin coating may be performed at a coating rate of about 2,000 revolutions per minute (rpm) to about 5,000 rpm and at a heat treatment temperature of about 80 °C to about 200 °C, depending on the material to be included in each layer and the structure of each layer to be formed.

The term "C₁-C₆₀ alkyl group" as used herein refers to a linear or branched aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having the same structure as the C₁-C₆₀ alkyl group.

The term "C₂-C₆₀ alkenyl group" as used herein refers to a hydrocarbon group having at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group having at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is a C₁-C₆₀ alkyl group). Examples thereof include a methoxy group, an ethoxy group, and an isopropyloxy group.

The term "C₃-C₁₀ cycloalkyl group" as used herein refers to a monovalent saturated hydrocarbon monocyclic group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group including at least one heteroatom selected from N, O, Si, P, and S as a ring-forming atom and 1 to 10 carbon atoms. Examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one double bond in its ring, and is not aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group including at least one heteroatom selected from N, O, Si, P, and S as a ring-forming atom, 1 to 10 carbon atoms, and at least one double bond in its ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkylene group" as used herein refers to a divalent group having the same structure as the C₁-C₁₀ heterocycloalkyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused.

The term "C₁-C₆₀ heteroaryl group" as used herein refers to a monovalent group having a heterocyclic aromatic system having at least one heteroatom selected from N, O, Si, P, and S as a ring-forming atom and 1 to 60 carbon atoms. The term "C₁-C₆₀ heteroarylene group" as used herein refers to a divalent group having a heterocyclic aromatic system having at least one heteroatom selected from N, O, Si, P, and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group).

The term "C₁-C₆₀ heteroaryloxy group" as used herein indicates -OA₁₀₄ (wherein A₁₀₄ is a C₁-C₆₀ heteroaryl group). The term "C₁-C₆₀ heteroarylthio group" as used herein indicates -SA₁₀₅ (wherein A₁₀₅ is a C₁-C₆₀ heteroaryl group).

The term "monovalent non-aromatic condensed polycyclic group" as used herein refers to a monovalent group that has two or more rings condensed and only carbon atoms as ring forming atoms (e.g., 8 to 60 carbon atoms), wherein the entire molecular structure is non-aromatic. Examples of the monovalent non-aromatic condensed polycyclic group may include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom selected from N, O, Si, P, and S, in addition to carbon atoms (e.g., 1 to 60 carbon atoms), as a ring-forming atom, wherein the entire molecular structure is non-aromatic. Examples of the monovalent non-aromatic condensed heteropolycyclic group may include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₆₀ carbocyclic group" as used herein refers to a monocyclic or polycyclic group having 5 to 60 carbon atoms only as ring-forming atoms. The C₅-C₆₀ carbocyclic group may be an aromatic carbocyclic group or a non-aromatic carbocyclic group. The term "C₅-C₆₀ carbocyclic group" as used herein refers to a ring (e.g., a benzene group), a monovalent group (e.g., a phenyl group), or a divalent group (e.g., a phenylene group). Also, depending on the number of substituents connected to the C₅-C₆₀ carbocyclic group, the C₅-C₆₀ carbocyclic group may be a trivalent group or a quadrivalent group.

The term "C₁-C₆₀ heterocyclic group" as used herein refers to a group having substantially the same structure as the C₅-C₆₀ carbocyclic group, except that at least one heteroatom selected from N, O, Si, P, and S is used as a ring-forming atom, in addition to carbon atoms (e.g., 1 to 60 carbon atoms).

In the present specification, at least one substituent of the substituted C₅-C₆₀ carbocyclic group, the substituted C₁-C₆₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and - P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one selected from deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂), and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group.

The term "Ph" as used herein refers to a phenyl group. The term "Me" as used herein refers to a methyl group. The term "Et" as used herein refers to an ethyl group. The term "ter-Bu" or "Bu^{t}" as used herein refers to a tert-butyl group. The term "OMe" as used herein refers to a methoxy group.

The term "biphenyl group" as used herein refers to a phenyl group substituted with a phenyl group. The "biphenyl group" may be a substituted phenyl group having a C₆-C₆₀ aryl group as a substituent.

The term "terphenyl group" as used herein refers to a phenyl group substituted with a biphenyl group. The "terphenyl group" may be a substituted phenyl group having a C₆-C₆₀ aryl group substituted with a C₆-C₆₀ aryl group as a substituent.

The symbols * and *' as used herein, unless defined otherwise, refer to a binding site to an adjacent atom in a corresponding formula.

## Claims

1. An organic light-emitting device (1) comprising:
an anode (110);
a cathode (120);
an organic layer (130) located between the anode (110) and the cathode (120) and comprising an emission layer (131);
an electron blocking layer (132) located between the anode (110) and the emission layer (131) and in direct contact with the emission layer (131); and
a hole blocking layer (133) located between the cathode (120) and the emission layer (131) and in direct contact with the emission layer (131),
wherein the emission layer (131) comprises a host and a dopant,
the electron blocking layer (132) comprises an electron blocking material,
the hole blocking layer (133) comprises a hole blocking material, and
the host, the dopant, the electron blocking material, and the hole blocking material each satisfy Equations 1-1 to 1-4: $T 1 \left(EB\right) \geq T 1 \left(H\right)$ Equation 1-1 $T 1 \left(EB\right) \geq T 1 \left(D\right)$ Equation 1-2 $T 1 \left(HB\right) > T 1 \left(H\right)$ Equation 1-3 $T 1 \left(HB\right) > T 1 \left(D\right)$ Equation 1-4
wherein, in Equations 1-1 and 1-4,
T1(EB) indicates a lowest excited triplet energy level of the electron blocking material,
T1(HB) indicates a lowest excited triplet energy level of the hole blocking material,
T1(H) indicates a lowest excited triplet energy level of the host, and
T1(D) indicates a lowest excited triplet energy level of the dopant,
wherein the organic layer (130) comprises an electron transport layer between the cathode (120) and the hole blocking layer (133), the electron transport layer comprises an electron transporting material,
the dopant and the electron transporting material each satisfy Equation 7: $T 1 \left(D\right) \geq T 1 \left(ET\right)$ Equation 7
wherein, in Equation 7,
T1(D) indicates a lowest excited triplet energy level of the dopant, and
T1(ET) indicates a lowest excited triplet energy level of the electron transporting material,
**characterized in that**
the host comprises a first host and a second host,
wherein the first host comprises a compound represented by Formula 1, and the second host comprises a compound represented by Formula 2: 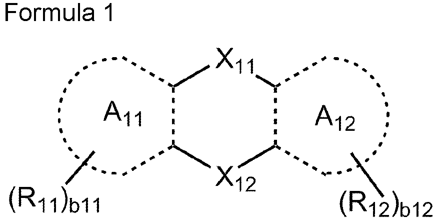 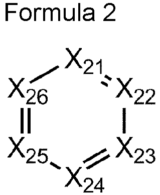
wherein, in Formulae 1 and 2,
X₁₁ is selected from O, S, N(R₁₃), and C(R₁₃)(R₁₄),
X₁₂ is selected from a single bond, O, S, N(R₁₅), and C(R₁₅)(R₁₆),
A₁₁ and A₁₂ are each independently selected from a C₅-C₆₀ carbocyclic group and a C₁-C₆₀ heterocyclic group,
R₁₁ to R₁₆ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁),
-S(=O)₂(Q₁), -P(=O)(Q₁)(Q₂), and -P(=S)(Q₁)(Q₂),
b11 and b12 are each independently selected from 1, 2, 3, 4, 5, and 6,
wherein Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a biphenyl group, and a terphenyl group,
X₂₁ is N or C(R₂₁), X₂₂ is N or C(R₂₂), X₂₃ is N or C(R₂₃), X₂₄ is N or C(R₂₄), X₂₅ is N or C(R₂₅), and X₂₆ is N or C(R₂₆), provided that at least one of X₂₁ to X₂₆ is N,
R₂₁ to R₂₆ are each independently selected from hydrogen, deuterium, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
at least one of R₂₁ to R₂₆ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

2. The organic light-emitting device (1) of claim 1, wherein the host, the dopant, the electron blocking material, and the hole blocking material each satisfy Equations 1-11, 1-21, 1-31, and/or 1-41: $1.0 eV \geq T 1 \left(EB\right) - T 1 \left(H\right) \geq 0.01 eV$ Equation 1-11 $1.0 eV \geq T 1 \left(EB\right) - T 1 \left(D\right) \geq 0.01 eV$ Equation 1-21 $1.0 eV \geq T 1 \left(HB\right) - T 1 \left(H\right) \geq 0.01 eV$ Equation 1-31 $1.0 eV \geq T 1 \left(HB\right) - T 1 \left(D\right) \geq 0.01 eV$ Equation 1-41 wherein, in Equations 1-11, 1-21, 1-31, and 1-41,
T1(EB) indicates a lowest excited triplet energy level of the electron blocking material,
T1(HB) indicates a lowest excited triplet energy level of the hole blocking material,
T1(H) indicates a lowest excited triplet energy level of the host, and
T1(D) indicates a lowest excited triplet energy level of the dopant.

3. The organic light-emitting device (1) of claim 1, wherein the electron blocking material comprises a compound represented by Formula 1: 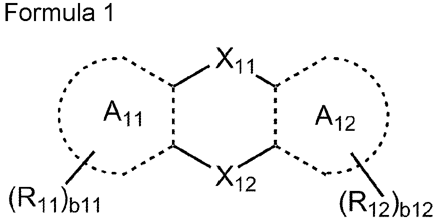 wherein, in Formula 1,
X₁₁ is selected from O, S, N(R₁₃), and C(R₁₃)(R₁₄),
X₁₂ is selected from a single bond, O, S, N(R₁₅), and C(R₁₅)(R₁₆),
A₁₁ and A₁₂ are each independently selected from a C₅-C₆₀ carbocyclic group and a C₁-C₆₀ heterocyclic group,
R₁₁ to R₁₆ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂), and
b11 and b12 are each independently selected from 1, 2, 3, 4, 5, and 6,
wherein Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a biphenyl group, and a terphenyl group.

4. The organic light-emitting device (1) of claim 1, wherein a thickness (D_{E}) of the emission layer (131) ≥ a thickness (D_{EB}) of the electron blocking layer (132).

5. The organic light-emitting device (1) of claim 1, wherein a thickness of the electron blocking layer (132) is in a range of 5 - 20 nm [50 - 200 Å].

6. The organic light-emitting device (1) of claim 1, wherein the hole blocking material comprises a compound represented by Formula 2: 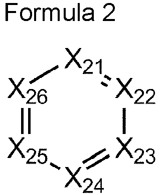 wherein, in Formula 2,
X₂₁ is N or C(R₂₁), X₂₂ is N or C(R₂₂), X₂₃ is N or C(R₂₃), X₂₄ is N or C(R₂₄), X₂₅ is N or C(R₂₅), and X₂₆ is N or C(R₂₆), provided that at least one of X₂₁ to X₂₆ is N,
R₂₁ to R₂₆ are each independently selected from hydrogen, deuterium, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
at least one of R₂₁ to R₂₆ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

7. The organic light-emitting device (1) of claim 1, wherein a thickness (D_{E}) of the emission layer (131) ≥ a thickness (D_{HB}) of the hole blocking layer (133).

8. The organic light-emitting device (1) of claim 1, wherein a thickness of the hole blocking layer (133) is in a range of 5 - 20 nm [50 - 200 Å].

9. The organic light-emitting device (1) of claim 1, wherein the first host is a hole transporting host not comprising an electron transporting moiety, and the second host is an electron transporting host comprising an electron transporting moiety.

10. The organic light-emitting device (1) of claim 1, wherein the first host is identical to the electron blocking material.

11. The organic light-emitting device (1) of claim 1, wherein the second host is identical to the hole blocking material.

12. The organic light-emitting device (1) of claim 1, wherein the dopant emits delayed fluorescence or fluorescence.

13. The organic light-emitting device (1) of claim 1, wherein the dopant further satisfies Equation 3: $\left|S1\left(D\right)-T1\left(D\right)\right| \leq 0.5 eV$ Equation 3 wherein, in Equation 3,
T1(D) indicates a lowest excited triplet energy level of the dopant, and
S1(D) indicates a lowest excited singlet energy level of the dopant.

14. The organic light-emitting device (1) of claim 1, wherein the dopant further satisfies Equation 4 and/or Equation 5: $2.65 eV \leq S 1 \left(D\right) \leq 2.85 eV$ Equation 4 $2.65 eV \leq T 1 \left(D\right) \leq 3.05 eV$ Equation 5 wherein, in Equations 4 and 5,
T1(D) indicates a lowest excited triplet energy level of the dopant, and
S1(D) indicates a lowest excited singlet energy level of the dopant.

15. The organic light-emitting device (1) of claim 1, wherein
the organic layer (130) comprises a hole transport layer between the anode (110) and the electron blocking layer (132),
the hole transport layer comprises a hole transporting material, and
the host and the hole transporting material each satisfy Equation 6: $T 1 \left(H\right) \geq T 1 \left(HT\right)$ Equation 6
wherein, in Equation 6,
T1(H) indicates a lowest excited triplet energy level of the host, and
T1(HT) indicates a lowest excited triplet energy level of the hole transporting material.

## Patentansprüche

1. Organische lichtemittierende Vorrichtung (1), umfassend:
eine Anode (110);
eine Kathode (120);
eine organische Schicht (130), die sich zwischen der Anode (110) und der Kathode (120) befindet und eine Emissionsschicht (131) umfasst;
eine Elektronenblockierschicht (132), die sich zwischen der Anode (110) und der Emissionsschicht (131) und in direktem Kontakt mit der Emissionsschicht (131) befindet; und
eine Lochblockierschicht (133), die sich zwischen der Kathode (120) und der Emissionsschicht (131) und in direktem Kontakt mit der Emissionsschicht (131) befindet,
wobei die Emissionsschicht (131) einen Wirt und einen Dotierstoff umfasst,
die Elektronenblockierschicht (132) ein Elektronenblockiermaterial umfasst,
die Lochblockierschicht (133) ein Lochblockiermaterial umfasst und
der Wirt, der Dotierstoff, das Elektronenblockiermaterial und das Lochblockiermaterial jeweils die Gleichungen 1-1 bis 1-4 erfüllen: $T 1 \left(EB\right) \geq T 1 \left(H\right)$ Gleichung 1-1 $T 1 \left(EB\right) \geq T 1 \left(D\right)$ Gleichung 1-2 $T 1 \left(HB\right) > T 1 \left(H\right)$ Gleichung 1-3 $T 1 \left(HB\right) > T 1 \left(D\right)$ Gleichung 1-4
wobei in den Gleichungen 1-1 und 1-4
T1(EB) einen niedrigsten angeregten Triplettenergiepegel des Elektronenblockiermaterials angibt,
T1(HB) einen niedrigsten angeregten Triplettenergiepegel des Lochblockiermaterials angibt,
T1(H) einen niedrigsten angeregten Triplettenergiepegel des Wirts angibt und T1(D) einen niedrigsten angeregten Triplettenergiepegel des Dotierstoffs angibt, wobei die organische Schicht (130) eine Elektronentransportschicht zwischen der Kathode (120) und der Lochblockierschicht (133) umfasst, die Elektronentransportschicht ein Elektronentransportmaterial umfasst,
der Dotierstoff und das Elektronentransportmaterial jeweils Gleichung 7 erfüllen: $T 1 \left(D\right) \geq T 1 \left(ET\right)$ Gleichung 7
wobei in Gleichung 7
T1(D) einen niedrigsten angeregten Triplettenergiepegel des Dotierstoffs angibt
und
T1(ET) einen niedrigsten angeregten Triplettenergiepegel des Elektronentransportmaterials angibt,
**dadurch gekennzeichnet, dass**
der Wirt einen ersten Wirt und einen zweiten Wirt umfasst,
wobei der erste Wirt eine Verbindung umfasst, die durch die Formel 1 dargestellt ist, und der zweite Wirt eine Verbindung umfasst, die durch die Formel 2 dargestellt ist: 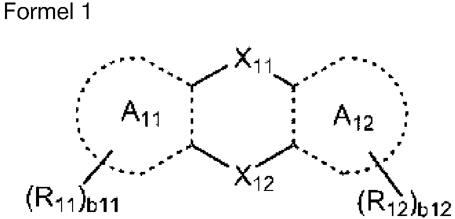 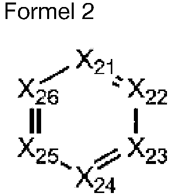
wobei in Formel 1 und 2
X₁₁ ausgewählt ist aus O, S, N(R₁₃) und C(R₁₃)(R₁₄),
X₁₂ ausgewählt ist aus einer Einfachbindung, O, S, N(R₁₅) und C(R₁₅)(R₁₆),
A₁₁ und A₁₂ jeweils unabhängig ausgewählt sind aus einer carbocyclischen C₅-C₆₀-Gruppe und einer heterocyclischen C₁-C₆₀-Gruppe,
R₁₁ bis R₁₆ jeweils unabhängig ausgewählt sind aus Wasserstoff, Deuterium, -F, - Cl, -Br, -I, einer Hydroxyl-Gruppe, einer Cyano-Gruppe, einer Nitro-Gruppe, einer Amidino-Gruppe, einer Hydrazino-Gruppe, einer Hydrazono-Gruppe, einer substituierten oder unsubstituierten C₁-C₆₀-Alkyl-Gruppe, einer substituierten oder unsubstituierten C₂-C₆₀-Alkenyl-Gruppe, einer substituierten oder unsubstituierten C₂-C₆₀-Alkinyl-Gruppe, einer substituierten oder unsubstituierten C₁-C₆₀-AlkoxyGruppe, einer substituierten oder unsubstituierten C₃-C₁₀-Cycloalkyl-Gruppe, einer substituierten oder unsubstituierten C₁-C₁₀-Heterocycloalkyl-Gruppe, einer substituierten oder unsubstituierten C₃-C₁₀-Cycloalkenyl-Gruppe, einer substituierten oder unsubstituierten C₁-C₁₀-Heterocycloalkenyl-Gruppe, einer substituierten oder unsubstituierten C₆-C₆₀-Aryl-Gruppe, einer substituierten oder unsubstituierten C₆-C₆₀-Aryloxy-Gruppe, einer substituierten oder unsubstituierten C₆-C₆₀-Arylthio-Gruppe, einer substituierten oder unsubstituierten C₁-C₆₀-Heteroaryl-Gruppe, einer substituierten oder unsubstituierten C₁-C₆₀-Heteroaryloxy-Gruppe, einer substituierten oder unsubstituierten C₁-C₆₀-Heteroarylthio-Gruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂) und -P(=S)(Q₁)(Q₂), b11 und b12 jeweils unabhängig ausgewählt sind aus 1, 2, 3, 4, 5 und 6,
wobei Q₁ bis Q₃ jeweils unabhängig ausgewählt sind aus Wasserstoff, Deuterium, -F, -Cl, -Br, -I, einer Hydroxyl-Gruppe, einer Cyano-Gruppe, einer Nitro-Gruppe, einer Amidino-Gruppe, einer Hydrazino-Gruppe, einer Hydrazono-Gruppe, einer C₁-C₆₀-Alkyl-Gruppe, einer C₂-C₆₀-Alkenyl-Gruppe, einer C₂-C₆₀-Alkinyl-Gruppe, einer C₁-C₆₀-Alkoxy-Gruppe, einer C₃-C₁₀-Cycloalkyl-Gruppe, einer C₁-C₁₀-Heterocycloalkyl-Gruppe, einer C₃-C₁₀-Cycloalkenyl-Gruppe, einer C₁-C₁₀-Heterocycloalkenyl-Gruppe, einer C₆-C₆₀-Aryl-Gruppe, einer C₆-C₆₀-AryloxyGruppe, einer C₆-C₆₀-Arylthio-Gruppe, einer C₁-C₆₀-Heteroaryl-Gruppe, einer C₁-C₆₀-Heteroaryloxy-Gruppe, einer C₁-C₆₀-Heteroarylthio-Gruppe, einer einwertigen nicht aromatischen kondensierten polycyclischen Gruppe, einer einwertigen nicht aromatischen kondensierten heteropolycyclischen Gruppe, einer Biphenyl-Gruppe und einer Terphenyl-Gruppe,
X₂₁ N oder C(R₂₁) ist, X₂₂ N oder C(R₂₂) ist, X₂₃ N oder C(R₂₃) ist, X₂₄ N oder C(R₂₄) ist, X₂₅ N oder C(R₂₅) IST und X₂₆ N oder C(R₂₆) ist, vorausgesetzt, dass mindestens eines von X₂₁ bis X₂₆ N ist,
R₂₁ bis R₂₆ jeweils unabhängig ausgewählt sind aus Wasserstoff, Deuterium, einer substituierten oder unsubstituierten C₆-C₆₀-Aryl-Gruppe, einer substituierten oder unsubstituierten C₁-C₆₀-Heteroaryl-Gruppe, einer substituierten oder unsubstituierten einwertigen nicht aromatischen kondensierten polycyclischen Gruppe und einer substituierten oder unsubstituierten einwertigen nicht aromatischen kondensierten heteropolycyclischen Gruppe und
mindestens eines von R₂₁ bis R₂₆ ausgewählt ist aus einer substituierten oder unsubstituierten C₆-C₆₀-Aryl-Gruppe, einer substituierten oder unsubstituierten C₁-C₆₀-Heteroaryl-Gruppe, einer substituierten oder unsubstituierten einwertigen nicht aromatischen kondensierten polycyclischen Gruppe und einer substituierten oder unsubstituierten einwertigen nicht aromatischen kondensierten heteropolycyclischen Gruppe.

2. Organische lichtemittierende Vorrichtung (1) nach Anspruch 1, wobei der Wirt, der Dotierstoff, das Elektronenblockiermaterial und das Lochblockiermaterial jeweils die Gleichungen 1-11, 1-21, 1-31 und/oder 1-41 erfüllen: $1 , 0 eV \geq T 1 \left(EB\right) - T 1 \left(H\right) \geq 0 , 01 eV$ Gleichung 1-11 $1 , 0 eV \geq T 1 \left(EB\right) - T 1 \left(D\right) \geq 0 , 01 eV$ Gleichung 1-21 $1 , 0 eV \geq T 1 \left(HB\right) - T 1 \left(H\right) \geq 0 , 01 eV$ Gleichung 1-31 $1 , 0 eV \geq T 1 \left(HB\right) - T 1 \left(D\right) \geq 0 , 01 eV$ Gleichung 1-41 wobei in den Gleichungen 1-11, 1-21, 1-31 und 1-41
T1(EB) einen niedrigsten angeregten Triplettenergiepegel des Elektronenblockiermaterials angibt,
T1(HB) einen niedrigsten angeregten Triplettenergiepegel des Lochblockiermaterials angibt,
T1(H) einen niedrigsten angeregten Triplettenergiepegel des Wirts angibt und
T1(D) einen niedrigsten angeregten Triplettenergiepegel des Dotierstoffs angibt.

3. Organische lichtemittierende Vorrichtung (1) nach Anspruch 1, wobei das Elektronenblockiermaterial eine Verbindung umfasst, die durch die Formel 1 dargestellt ist: 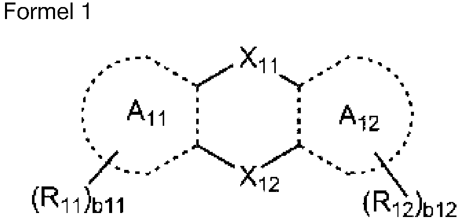 wobei in Formel 1
X₁₁ ausgewählt ist aus O, S, N(R₁₃) und C(R₁₃)(R₁₄),
X₁₂ ausgewählt ist aus einer Einfachbindung, O, S, N(R₁₅) und C(R₁₅)(R₁₆),
A₁₁ und A₁₂ jeweils unabhängig ausgewählt sind aus einer carbocyclischen C₅-C₆₀-Gruppe und einer heterocyclischen C₁-C₆₀-Gruppe,
R₁₁ bis R₁₆ jeweils unabhängig ausgewählt sind aus Wasserstoff, Deuterium, -F, - Cl, -Br, -I, einer Hydroxyl-Gruppe, einer Cyano-Gruppe, einer Nitro-Gruppe, einer Amidino-Gruppe, einer Hydrazino-Gruppe, einer Hydrazono-Gruppe, einer substituierten oder unsubstituierten C₁-C₆₀-Alkyl-Gruppe, einer substituierten oder unsubstituierten C₂-C₆₀-Alkenyl-Gruppe, einer substituierten oder unsubstituierten C₂-C₆₀-Alkinyl-Gruppe, einer substituierten oder unsubstituierten C₁-C₆₀-AlkoxyGruppe, einer substituierten oder unsubstituierten C₃-C₁₀-Cycloalkyl-Gruppe, einer substituierten oder unsubstituierten C₁-C₁₀-Heterocycloalkyl-Gruppe, einer substituierten oder unsubstituierten C₃-C₁₀-Cycloalkenyl-Gruppe, einer substituierten oder unsubstituierten C₁-C₁₀-Heterocycloalkenyl-Gruppe, einer substituierten oder unsubstituierten C₆-C₆₀-Aryl-Gruppe, einer substituierten oder unsubstituierten C₆-C₆₀-Aryloxy-Gruppe, einer substituierten oder unsubstituierten C₆-C₆₀-Arylthio-Gruppe, einer substituierten oder unsubstituierten C₁-C₆₀-Heteroaryl-Gruppe, einer substituierten oder unsubstituierten C₁-C₆₀-Heteroaryloxy-Gruppe, einer substituierten oder unsubstituierten C₁-C₆₀-Heteroarylthio-Gruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂) und -P(=S)(Q₁)(Q₂) und
b11 und b12 jeweils unabhängig ausgewählt sind aus 1, 2, 3, 4, 5 und 6,
wobei Q₁ bis Q₃ jeweils unabhängig ausgewählt sind aus Wasserstoff, Deuterium, -F, -Cl, -Br, -I, einer Hydroxyl-Gruppe, einer Cyano-Gruppe, einer Nitro-Gruppe, einer Amidino-Gruppe, einer Hydrazino-Gruppe, einer Hydrazono-Gruppe, einer C₁-C₆₀-Alkyl-Gruppe, einer C₂-C₆₀-Alkenyl-Gruppe, einer C₂-C₆₀-Alkinyl-Gruppe, einer C₁-C₆₀-Alkoxy-Gruppe, einer C₃-C₁₀-Cycloalkyl-Gruppe, einer C₁-C₁₀-Heterocycloalkyl-Gruppe, einer C₃-C₁₀-Cycloalkenyl-Gruppe, einer C₁-C₁₀-Heterocycloalkenyl-Gruppe, einer C₆-C₆₀-Aryl-Gruppe, einer C₆-C₆₀-AryloxyGruppe, einer C₆-C₆₀-Arylthio-Gruppe, einer C₁-C₆₀-Heteroaryl-Gruppe, einer C₁-C₆₀-Heteroaryloxy-Gruppe, einer C₁-C₆₀-Heteroarylthio-Gruppe, einer einwertigen nicht aromatischen kondensierten polycyclischen Gruppe, einer einwertigen nicht aromatischen kondensierten heteropolycyclischen Gruppe, einer Biphenyl-Gruppe und einer Terphenyl-Gruppe.

4. Organische lichtemittierende Vorrichtung (1) nach Anspruch 1, wobei eine Dicke (D_{E}) der Emissionsschicht (131) ≥ einer Dicke (D_{EB}) der Elektronenblockierschicht (132) ist.

5. Organische lichtemittierende Vorrichtung (1) nach Anspruch 1, wobei eine Dicke der Elektronenblockierschicht (132) in einem Bereich von 5-20 nm [50-200 Å] liegt.

6. Organische lichtemittierende Vorrichtung (1) nach Anspruch 1, wobei das Lochblockiermaterial eine Verbindung umfasst, die durch die Formel 2 dargestellt ist: Formel 2: 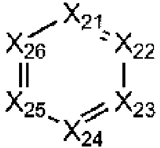 wobei in Formel 2
X₂₁ N oder C(R₂₁) ist, X₂₂ N oder C(R₂₂) ist, X₂₃ N oder C(R₂₃) ist, X₂₄ N oder C(R₂₄) ist, X₂₅ N oder C(R₂₅) ist und X₂₆ N oder C(R₂₆) ist, vorausgesetzt, dass mindestens eines von X₂₁ bis X₂₆ N ist,
R₂₁ bis R₂₆ jeweils unabhängig ausgewählt sind aus Wasserstoff, Deuterium, einer substituierten oder unsubstituierten C₆-C₆₀-Aryl-Gruppe, einer substituierten oder unsubstituierten C₁-C₆₀-Heteroaryl-Gruppe, einer substituierten oder unsubstituierten einwertigen nicht aromatischen kondensierten polycyclischen Gruppe und einer substituierten oder unsubstituierten einwertigen nicht aromatischen kondensierten heteropolycyclischen Gruppe und
mindestens eines von R₂₁ bis R₂₆ ausgewählt ist aus einer substituierten oder unsubstituierten C₆-C₆₀-Aryl-Gruppe, einer substituierten oder unsubstituierten C₁-C₆₀-Heteroaryl-Gruppe, einer substituierten oder unsubstituierten einwertigen nicht aromatischen kondensierten polycyclischen Gruppe und einer substituierten oder unsubstituierten einwertigen nicht aromatischen kondensierten heteropolycyclischen Gruppe.

7. Organische lichtemittierende Vorrichtung (1) nach Anspruch 1, wobei eine Dicke (D_{E}) der Emissionsschicht (131) ≥ einer Dicke (D_{HB}) der Lochblockierschicht (133) ist.

8. Organische lichtemittierende Vorrichtung (1) nach Anspruch 1, wobei eine Dicke der Lochblockierschicht (133) in einem Bereich von 5-20 nm [50-200 Å] liegt.

9. Organische lichtemittierende Vorrichtung (1) nach Anspruch 1, wobei der erste Wirt ein Lochtransportwirt ist, der keine Elektronentransporteinheit umfasst, und der zweite Wirt ein Elektronentransportwirt ist, der eine Elektronentransporteinheit umfasst.

10. Organische lichtemittierende Vorrichtung (1) nach Anspruch 1, wobei der erste Wirt identisch mit dem Elektronenblockiermaterial ist.

11. Organische lichtemittierende Vorrichtung (1) nach Anspruch 1, wobei der zweite Wirt identisch mit dem Lochblockiermaterial ist.

12. Organische lichtemittierende Vorrichtung (1) nach Anspruch 1, wobei der Dotierstoff verzögerte Fluoreszenz oder Fluoreszenz emittiert.

13. Organische lichtemittierende Vorrichtung (1) nach Anspruch 1, wobei der Dotierstoff ferner Gleichung 3 erfüllt: $\left|S1\left(D\right)-T1\left(D\right)\right| \leq 0 , 5 eV$ Gleichung 3 wobei in Gleichung 3
T1(D) einen niedrigsten angeregten Triplettenergiepegel des Dotierstoffs angibt
und
S1(D) einen niedrigsten angeregten Singulettenergiepegel des Dotierstoffs angibt.

14. Organische lichtemittierende Vorrichtung (1) nach Anspruch 1, wobei der Dotierstoff ferner Gleichung 4 und/oder Gleichung 5 erfüllt: $2 , 65 eV \leq S 1 \left(D\right) \leq 2 , 85 eV$ Gleichung 4 $2 , 65 eV \leq T 1 \left(D\right) \leq 3 , 05 eV$ Gleichung 5 wobei in Gleichung 4 und 5
T1(D) einen niedrigsten angeregten Triplettenergiepegel des Dotierstoffs angibt
und
S1(D) einen niedrigsten angeregten Singulettenergiepegel des Dotierstoffs angibt.

15. Organische lichtemittierende Vorrichtung (1) nach Anspruch 1, wobei die organische Schicht (130) eine Lochtransportschicht zwischen der Anode (110) und der Elektronenblockierschicht (132) umfasst,
die Lochtransportschicht ein Lochtransportmaterial umfasst und
der Wirt und das Lochtransportmaterial jeweils Gleichung 6 erfüllen: $T 1 \left(H\right) \geq T 1 \left(HT\right)$ Gleichung 6
wobei in Gleichung 6
T1(H) einen niedrigsten angeregten Triplettenergiepegel des Wirts angibt und
T1(HT) einen niedrigsten angeregten Triplettenergiepegel des Lochtransportmaterials angibt.

## Revendications

1. Dispositif électroluminescent organique (1) comprenant :
une anode (110) ;
une cathode (120) ;
une couche organique (130) située entre l'anode (110) et la cathode (120) et comprenant une couche d'émission (131) ;
une couche de blocage d'électrons (132) située entre l'anode (110) et la couche d'émission (131) et en contact direct avec la couche d'émission (131) ; et
une couche de blocage de trous (133) située entre la cathode (120) et la couche d'émission (131) et en contact direct avec la couche d'émission (131),
dans lequel la couche d'émission (131) comprend un hôte et un dopant,
la couche de blocage d'électrons (132) comprend un matériau de blocage d'électrons,
la couche de blocage de trous (133) comprend un matériau de blocage de trous,
et
l'hôte, le dopant, le matériau de blocage d'électrons et le matériau de blocage de trous satisfont chacun aux équations 1-1 à 1-4 : $T 1 \left(EB\right) \geq T 1 \left(H\right)$ Equation 1-1 $T 1 \left(EB\right) \geq T 1 \left(D\right)$ Equation 1-2 $T 1 \left(HB\right) > T 1 \left(H\right)$ Equation 1-3 $T 1 \left(HB\right) > T 1 \left(D\right)$ Equation 1-4
dans lequel, dans les équations 1-1 et 1-4,
T1(EB) indique un niveau d'énergie triplet excité le plus bas du matériau de blocage d'électrons,
T1(HB) indique un niveau d'énergie triplet excité le plus bas du matériau de blocage de trous,
T1(H) indique un niveau d'énergie triplet excité le plus bas de l'hôte, et
T1(D) indique un niveau d'énergie triplet excité le plus bas du dopant,
dans lequel la couche organique (130) comprend une couche de transport d'électrons entre la cathode (120) et la couche de blocage de trous (133), la couche de transport d'électrons comprend un matériau de transport d'électrons, le dopant et le matériau de transport d'électrons satisfont chacun à l'équation 7 : $T 1 \left(D\right) \geq T 1 \left(ET\right)$ Equation 7
dans lequel, dans l'équation 7,
T1(D) indique un niveau d'énergie triplet excité le plus bas du dopant, et
T1(ET) indique un niveau d'énergie triplet excité le plus bas du matériau de transport d'électrons,
**caractérisé en ce que**
l'hôte comprend un premier hôte et un deuxième hôte,
dans lequel le premier hôte comprend un composé représenté par la formule 1,
et le deuxième hôte comprend un composé représenté par la formule 2 : 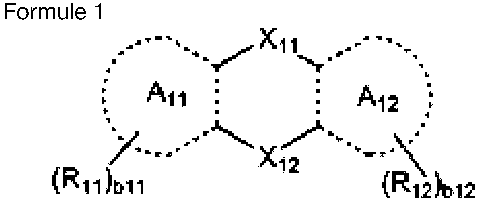 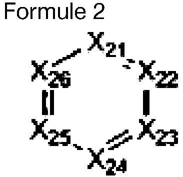
dans lesquelles, dans les formules 1 et 2,
X₁₁ est choisi parmi O, S, N(R₁₃) et C(R₁₃)(R₁₄),
X₁₂ est choisi parmi une simple liaison, O, S, N(R₁₅) et C(R₁₅)(R₁₆),
A₁₁ et A₁₂ sont chacun indépendamment choisis parmi un groupe carbocyclique en C₅-C₆₀ et un groupe hétérocyclique en C₁-C₆₀,
R₁₁ à R₁₆ sont chacun indépendamment choisis parmi l'hydrogène, le deutérium, -F,-CI, -Br, -|, un groupe hydroxyle, un groupe cyano, un groupe nitro, un groupe amidino, un groupe hydrazino, un groupe hydrazono, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -B(Q₁)(Q₂), -N(Q₁)(Q₂), -P(Q₁)(Q₂), -C(=O)Q₁), - S(=O)(Q₁), -S(=O)₂(Q₁), -P(=O)(Q₁)(Q₂) et -P(=S(Q₁)(Q₂), et
b11 et b12 sont chacun indépendamment choisis parmi 1, 2, 3, 4, 5 et 6,
dans lequel Q₁ à Q₃ sont chacun indépendamment choisis parmi l'hydrogène, le deutérium, -F,-CI, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₃-C₆₀, un groupe aryloxy en C₆-C₆₀, un groupe arylthio en C₆-C₆₀, un groupe hétéroaryle en C₁-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, un groupe biphényle et un groupe terphényle,
X₂₁ est N ou C(R₂₁), X₂₂ est N ou C(R₂₂), X₂₃ est N ou C(R₂₃), X₂₄ est N ou C(R₂₄), X₂₅ est N ou C(R₂₅), et X₂₆ est N ou C(R₂₆), à condition qu'au moins l'un de X₂₁ à X₂₆ soit N,
R₂₁ à R₂₆ sont chacun indépendamment choisis parmi l'hydrogène, le deutérium, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, et un groupe hétéropolycyclique condensé non aromatique monovalent substitué ou non substitué, et
au moins l'un de R₂₁ à R₂₆ est choisi parmi un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, et un groupe hétéropolycyclique condensé non aromatique monovalent substitué ou non substitué.

2. Dispositif électroluminescent organique (1) selon la revendication 1, dans lequel l'hôte, le dopant, le matériau de blocage d'électrons et le matériau de blocage de trous satisfont chacun aux équations 1-11, 1-21, 1-31 et/ou 1-41 : $1,0 eV \geq T 1 \left(EB\right) - T 1 \left(H\right) \geq 0 , 01 eV$ Equation 1-11 $1,0 eV \geq T 1 \left(EB\right) - T 1 \left(D\right) \geq 0 , 01 eV$ Equation 1-21 $1,0 eV \geq T 1 \left(HB\right) - T 1 \left(H\right) \geq 0 , 01 eV$ Equation 1-31 $1,0 eV \geq T 1 \left(HB\right) - T 1 \left(D\right) \geq 0 , 01 eV$ Equation 1-41 dans lequel, dans les équations 1-11, 1-21, 1-31 et 1-41,
T1(EB) indique un niveau d'énergie triplet excité le plus bas du matériau de blocage d'électrons,
T1(HB) indique un niveau d'énergie triplet excité le plus bas du matériau de blocage de trous,
T1(H) indique un niveau d'énergie triplet excité le plus bas de l'hôte, et
T1(D) indique un niveau d'énergie triplet excité le plus bas du dopant.

3. Dispositif électroluminescent organique (1) selon la revendication 1, dans lequel le matériau de blocage d'électrons comprend un composé représenté par la formule 1 : 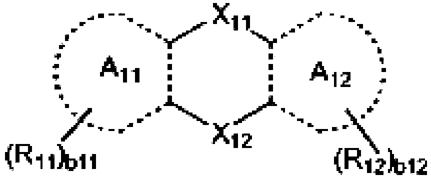 dans lequel, dans la formule 1,
X₁₁ est choisi parmi O, S, N(R₁₃) et C(R₁₃)(R₁₄),
X₁₂ est choisi parmi une simple liaison, O, S, N(R₁₅) et C(R₁₅)(R₁₆),
A₁₁ et A₁₂ sont chacun indépendamment choisis parmi un groupe carbocyclique en C₅-C₆₀ et un groupe hétérocyclique en C₁-C₆₀,
R₁₁ à R₁₆ sont chacun indépendamment choisis parmi l'hydrogène, le deutérium, -F,-CI, -Br, -|, un groupe hydroxyle, un groupe cyano, un groupe nitro, un groupe amidino, un groupe hydrazino, un groupe hydrazono, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -B(Q₁)(Q₂), -N(Q₁)(Q₂), -P(Q₁)(Q₂), -C(=O)Q₁), -S(=O)(Q₁), -S(=O)₂(Q₁), -P(=O(Q₁)(Q₂) et -P(=S)(Q₁)(Q₂), et
b11 et b12 sont chacun indépendamment choisis parmi 1, 2, 3, 4, 5 et 6,
où Q₁ à Q₃ sont chacun indépendamment choisis parmi l'hydrogène, le deutérium, -F,-CI, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, un groupe biphényle et un groupe terphényle.

4. Dispositif électroluminescent organique (1) selon la revendication 1, dans lequel une épaisseur (D_{E}) de la couche d'émission (131) ≥ une épaisseur (D_{EB}) de la couche de blocage d'électrons (132).

5. Dispositif électroluminescent organique (1) selon la revendication 1, dans lequel une épaisseur de la couche de blocage d'électrons (132) est dans une plage de 5 à 20 nm [50-200 Â].

6. Dispositif électroluminescent organique (1) selon la revendication 1, dans lequel le matériau de blocage de trous comprend un composé représenté par la formule 2 : 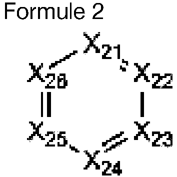 dans lequel, dans la formule 2,
X₂₁ est N ou C(R₂₁), X₂₂ est N ou C(R₂₂), X₂₃ est N ou C(R₂₃), X₂₄ est N ou C(R₂₄),
X₂₅ est N ou C(R₂₅), et X₂₆ est N ou C(R₂₆), à condition qu'au moins l'un de X₂₁ à X26 soit N,
R₂₁ à R₂₆ sont chacun indépendamment choisis parmi l'hydrogène, le deutérium, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, et un groupe hétéropolycyclique condensé non aromatique monovalent substitué ou non substitué, et
au moins l'un de R₂₁ à R₂₆ est choisi parmi un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, et un groupe hétéropolycyclique condensé non aromatique monovalent substitué ou non substitué.

7. Dispositif électroluminescent organique (1) selon la revendication 1, dans lequel une épaisseur (D_{E}) de la couche d'émission (131) ≥ une épaisseur (D_{HB}) de la couche de blocage de trous (133).

8. Dispositif électroluminescent organique (1) selon la revendication 1, dans lequel une épaisseur de la couche de blocage de trous (133) est dans une plage de 5 à 20 nm [50 à 200 Â].

9. Dispositif électroluminescent organique (1) selon la revendication 1, dans lequel le premier hôte est un hôte de transport de trous ne comprenant pas de fraction de transport d'électrons, et le deuxième hôte est un hôte de transport d'électrons comprenant une fraction de transport d'électrons.

10. Dispositif électroluminescent organique (1) selon la revendication 1, dans lequel le premier hôte est identique au matériau de blocage d'électrons.

11. Dispositif électroluminescent organique (1) selon la revendication 1, dans lequel le deuxième hôte est identique au matériau de blocage de trous.

12. Dispositif électroluminescent organique (1) selon la revendication 1, dans lequel le dopant émet une fluorescence retardée ou une fluorescence.

13. Dispositif électroluminescent organique (1) selon la revendication 1, dans lequel le dopant satisfait en outre à l'équation 3 : $\left|S1\left(D\right)-T1\left(D\right)\right| \leq 0 , 5 eV$ Equation 3 dans lequel, dans l'équation 3,
T1(D) indique un niveau d'énergie triplet excité le plus bas du dopant, et
S1(D) indique un niveau d'énergie singulet excité le plus bas du dopant.

14. Dispositif électroluminescent organique (1) selon la revendication 1, dans lequel le dopant satisfait en outre à l'équation 4 et/ou à l'équation 5 : $2,65 eV \leq S 1 \left(D\right) \leq 2 , 85 eV$ Equation 4 $2,65 eV \leq T 1 \left(D\right) \leq 3 , 05 eV$ Equation 5 dans lequel, dans les équations 4 et 5,
T1(D) indique un niveau d'énergie triplet excité le plus bas du dopant, et
S1(D) indique un niveau d'énergie singulet excité le plus bas du dopant.

15. Dispositif électroluminescent organique (1) selon la revendication 1, dans lequel la couche organique (130) comprend une couche de transport de trous entre l'anode (110) et la couche de blocage d'électrons (132),
la couche de transport de trous comprend un matériau de transport de trous, et
l'hôte et le matériau de transport de trous satisfont chacun à l'équation 6 : $T 1 \left(H\right) \geq T 1 \left(HT\right)$ Equation 6
dans lequel, dans l'équation 6,
T1(H) indique un niveau d'énergie triplet excité le plus bas de l'hôte, et
T1(HT) indique un niveau d'énergie triplet excité le plus bas du matériau de transport de trous.
